# EUROPEAN PATENT APPLICATION

(11) **EP 4 567 516 A1**
(43) Date of publication of application: **11.06.2025**
(21) Application number: 23849486.8
(22) Date of filing: 03.08.2023
(51) Int. Cl.: G03F 7/11, G03F 7/16, G03F 7/20, G03F 7/30

(54) **PHOTOLITHOGRAPHY METHOD AND PHOTOLITHOGRAPHY SYSTEM**

(30) Priority: 05.08.2022 CN 202210937838
(71) Applicant: Shanghai Optoelectronics Science and Technology Innovation Center, Shanghai 201210 (CN)
(72) Inventor: XU, Xiaobin, Pudong New District, Shanghai 201210 (CN); XIONG, Shisheng, Pudong New District, Shanghai 201210 (CN)
(74) Representative: Jacobs, Lambert
(86) International application number: PCT/CN2023/110894
(87) International publication number: WO 2024/027782

(57) **Abstract**

The present invention relates to a photolithography method and a photolithography system. The method comprises: (1) forming a negative photoresist layer on a substrate using a negative photoresist, and forming a positive photoresist layer on the negative photoresist layer using a positive photoresist; (2) patterning the negative photoresist layer and the positive photoresist layer to form a positive pattern region on the positive photoresist layer and a negative pattern region on the negative photoresist layer, wherein s size of the positive pattern region is larger than a size of the negative pattern region; (3) developing the positive photoresist layer with developer for positive photoresist to remove the positive photoresist in the positive pattern region; and (4) developing the negative photoresist layer with developer for negative photoresist to remove the negative photoresist located near the negative pattern region, thereby providing an exposed region associated with a size of the positive pattern region and a size the negative pattern region, to expose the substrate. Compared with existing single-exposure photolithography technology, the method of the present invention is simple and a line width smaller than that of the conventional technology can be achieved by pattern contouring. The method can be widely used in semiconductor process and has extensive values of research and application.

## Description

### FIELD OF THE INVENTION

The invention relates to the technical field of semiconductor microstructure processing, in particular to a photolithography method and a photolithography system.

### BACKGROUND

The rapid development of integrated circuits depends on the development of related manufacturing process, i.e., photolithography technology, which is processing technology of the highest precision that can be achieved so far. Photolithography is a kind of precise fine processing technique. Conventional photolithography technology is such a process which applies ultraviolet (UV) rays of a wavelength of 135-4500 Å as carriers for image information and applies photo-induced resist as an intermediate or image recording medium to transform, transfer and process patterns and eventually transfer the image information to a wafer (which mainly refers to a silicon wafer) or a medium layer.

In principle, the photolithography technology refers to technology to transfer the patterns on a mask to a substrate by means of photo-induced resists (also known as photoresists) with illumination of radiation. Its main process is as follows: first, ultraviolet rays travel through a mask and illuminates a surface of a substrate attached with a layer of photoresist film, which causes chemical reactions to occur in photoresists in the exposed region; then the photoresists in the exposed region or the unexposed region are removed through dissolution by developing technology, so that the patterns on the mask are duplicated to the film of the photoresists; finally, the patterns are transferred to a substrate through etching technology or deposition technology. The photoresists can mainly divided into positive photoresists and negative photoresists. The positive photoresists are characterized by its exposed portions being dissolved in the developer due to photochemical reactions occurring in the portions, while its portions not exposed not being dissolved in the developer. Negative photoresists are characterized by its exposed portions not being dissolved in the developer due to cross-linking solidity or photochemical reactions, while its unexposed portions being dissolved in the developer.

Photolithography is the most important processing in integrated circuits, similar to the role of a lathe for a metal workshop. Implementation of almost each process in the entire process of chip manufacturing would not be possible in the absence of photolithography technology. Photolithography is also the most critical technology in chip manufacturing and occupies over 35% of the costs for chip manufacturing.

The photolithography technology can mainly be categorized as optical lithography, for which common light sources include ultraviolet (UV) light source, deep ultraviolet (DUV) light source, extreme ultraviolet (EUV) light source, and particle beam lithography, common examples for which mainly include X-ray lithography, electron beam lithography and ion beam lithography, etc.

Generally, UV can only implement a resolution of about one micro for the patterns in optical lithography. Although a higher resolution can be implemented by DUV, EUV, etc., they are expensive. In addition, although electron beam lithography and focused ion beam lithography of particle beam lithography can also increase the resolution to some degree, the time-consuming writing process of multiple cycles is needed, which substantially reduce efficiency of work.

### SUMMARY

The purpose of the present invention is to overcome the deficiencies in prior arts as described above and to provide a photolithography method which is simple, achieves smaller width of lines than conventional technology, and can be widely used in semiconductor process and has extensive values of research and application.

The present invention is to solve the above problem(s), and aims to provide a photolithography method, in which pattern of contour lines based on the features of original mask patterns is obtained by making use of difference of response of positive and negative photoresists to a light source and difference of exposure energy obtained during exposure, and making use of difference of sizes of patterns after actual development of positive and negative photoresists matched with each other, wherein the line width of the pattern of contour lines is smaller than that of the features of the original mask pattern, so as to realize the multiplication of density of lines. Thereafter, the pattern can be further transferred to a target material by combining a deposition process or an etching process for materials of the substrate.

### Technical solution to solve the technical problem

In order to solve the above problem(s), the photolithography method according to a first aspect of the present invention comprises the steps of:
(1) forming a negative photoresist layer on a substrate using a negative photoresist, and forming a positive photoresist layer on the negative photoresist layer using a positive photoresist;
(2) patterning the negative photoresist layer and the positive photoresist layer to form a positive pattern region and a negative pattern region on the positive photoresist layer and the negative photoresist layer, respectively, wherein a size of the positive pattern region is larger than a size of the negative pattern region;
(3) developing the positive photoresist layer with developer for positive photoresist to remove the positive photoresist in the positive pattern region; and
(4) developing the negative photoresist layer with developer for negative photoresist to remove the negative photoresist located near the negative pattern region, thereby providing an exposed region associated with a size of the positive pattern region and a size of the negative pattern region, to expose the substrate.

**In** addition, the photolithography method according to a second aspect of the present invention comprises the steps of:
(1) forming a negative photoresist layer on a substrate using a negative photoresist, forming an interlayer on the negative photoresist layer, and forming a positive photoresist layer on the interlayer using a positive photoresist;
(2) patterning the negative photoresist layer and the positive photoresist layer to form a positive pattern region and a negative pattern region on the positive photoresist layer and the negative photoresist layer, respectively, wherein a size of the positive pattern region is larger than a size of the negative pattern region;
(3) developing the positive photoresist layer with developer for positive photoresist to remove the positive photoresist in the positive pattern region;
(4) developing the interlayer with developer for interlayer, or etching the interlayer with a pattern of the developed positive photoresist layer as an anti-etching mask, so that the pattern of the interlayer matches pattern of the developed positive photoresist layer; and
(5) developing the negative photoresist layer with developer for negative photoresist to remove the negative photoresist located near the negative pattern region, thereby providing an exposed region associated with a size of the positive pattern region and a size the negative pattern region, to expose the substrate.

**In** addition, the photolithography method according to a third aspect of the present invention comprises the steps of:
(1) forming a positive photoresist layer on a substrate using a positive photoresist, forming an interlayer on the positive photoresist layer, and forming a negative photoresist layer on the interlayer using a negative photoresist;
(2) patterning the negative photoresist layer and the positive photoresist layer to form a positive pattern region and a negative pattern region on the positive photoresist layer and the negative photoresist layer, respectively, wherein a size of the positive pattern region is larger than a size of the negative pattern region;
(3) developing the negative photoresist layer with developer for negative photoresist to remove the negative photoresist outside the negative pattern region;
(4) developing the interlayer with developer for interlayer, or etching the interlayer with a pattern of the developed negative photoresist layer as an anti-etching mask, so that the pattern of the interlayer matches pattern of the developed negative photoresist layer; and
(5) developing the positive photoresist layer with developer for positive photoresist to remove the positive photoresist at an edge portion of the positive pattern region, thereby providing an exposed region associated with a size of the positive pattern region and a size of the negative pattern region, to expose the substrate.

Further, in the step (2), under an exposure source, the positive photoresist layer and the negative photoresist layer are exposed by using a lithographic mask with a template pattern or by focused direct writing, thereby forming a positive pattern region and a negative pattern region on the positive photoresist layer and the negative photoresist layer, respectively.

Further, in the step (2), the positive photoresist layer and the negative photoresist layer are exposed through a lithography mask with the template pattern under an exposure source by means of a projection exposure; or the positive photoresist layer and the negative photoresist layer are exposed through a photolithographic mask with the template pattern under an exposure source by means of masking exposure; or the positive photoresist layer and the negative photoresist layer are exposed by reflection on a lithographic mask with the template pattern under an exposure source by means of reflective exposure.

Further, the focused direct writing includes ultraviolet direct writing, deep ultraviolet direct writing, extreme ultraviolet direct writing, ion beam direct writing, electron beam direct writing or X-ray direct writing.

Further, the wavelength of the source of exposure is 1-500 nm, and the temperature for the drying after the exposing is 30-300°C.

Further, the positive photoresist includes positive ultraviolet photoresist, positive deep ultraviolet photoresist, positive extreme ultraviolet photoresist, positive electron beam photoresist, positive ion beam photoresist or positive X-ray photoresist; the negative photoresist includes negative ultraviolet photoresist, negative deep ultraviolet photoresist, negative extreme ultraviolet photoresist, negative electron beam photoresist, negative ion beam photoresist or negative X-ray photoresist.

Further, the developer for positive photoresist is a developer corresponding to the positive photoresist, and the developer for negative photoresist is a developer corresponding to the negative photoresist.

Further, the photolithography method further comprises a step of forming a pattern on the substrate by material deposition technology or etching technology.

Further, the material deposition technology includes electrochemical deposition, electroplating, CVD deposition, laser sputtering, magnetron sputtering, thermal evaporation, electron beam evaporation or atomic deposition; the etching technology includes wet etching including electrochemical etching or selective etching liquid etching or dry etching including ion etching or chemical reactive ion etching.

Further, the material of the substrate includes semiconductor, metal, insulator, polymer or composite material.

Further, the interlayer comprises an inorganic substance, a polymer, or a composite material.

A fourth aspect of the present invention further provides a photolithographic system comprising a layer forming device, a patterning device, a positive photoresist developing device, and a negative photoresist developing device, the lithographic system is configured for performing steps of:
(1) using the layer forming device to form a negative photoresist layer on a substrate using a negative photoresist, and form a positive photoresist layer on the negative photoresist layer using a positive photoresist;
(2) using the patterning device to pattern the negative photoresist layer and the positive photoresist layer to form a positive pattern region and a negative pattern region on the positive photoresist layer and the negative photoresist layer, respectively, wherein a size of the positive pattern region is larger than a size of the negative pattern region;
(3) using the positive photoresist developing device to develop the positive photoresist layer with developer for positive photoresist to remove the positive photoresist in the positive pattern region; and
(4) using the negative photoresist developing device to develop the negative photoresist layer with developer for negative photoresist to remove the negative photoresist located near the negative pattern region, thereby providing an exposed region associated with a size of the positive pattern region and a size of the negative pattern region, to expose the substrate.

A fifth aspect of the present invention further provides a photolithographic system comprising a layer forming device, a patterning device, a positive photoresist developing device, an interlayer developing and etching device, and a negative photoresist developing device, the photolithographic system is configured for performing steps of:
(1) using the layer forming device to form a negative photoresist layer on a substrate using a negative photoresist, form an interlayer on the negative photoresist layer and form a positive photoresist layer on the interlayer using a positive photoresist;
(2) using the patterning device to pattern the negative photoresist layer and the positive photoresist layer to form a positive pattern region and a negative pattern region on the positive photoresist layer and the negative photoresist layer, respectively, wherein a size of the positive pattern region is larger than a size of the negative pattern region;
(3) using the positive photoresist developing device to develop the positive photoresist layer with developer for positive photoresist to remove the positive photoresist in the positive pattern region;
(4) using the interlayer developing and etching device to develop the interlayer with developer for interlayer, or etch the interlayer with a pattern of the developed positive photoresist layer as an anti-etching mask, so that the pattern of the interlayer matches pattern of the developed positive photoresist layer; and
(5) using the negative photoresist developing device to develop the negative photoresist layer with developer for negative photoresist to remove the negative photoresist located near the negative pattern region, thereby providing an exposed region associated with a size of the positive pattern region and a size of the negative pattern region, to expose the substrate.

A sixth aspect of the present invention further provides a photolithographic system comprising a layer forming device, a patterning device, a negative photoresist developing device, an interlayer developing and etching device, and a positive photoresist developing device, the photolithographic system is configured for performing steps of:
(1) using the layer forming device to form a positive photoresist layer on a substrate using a positive photoresist, form an interlayer on the positive photoresist layer and form a negative photoresist layer on the interlayer using a negative photoresist;
(2) using the patterning device to pattern the negative photoresist layer and the positive photoresist layer to form a positive pattern region and a negative pattern region on the positive photoresist layer and the negative photoresist layer, respectively, wherein a size of the positive pattern region is larger than a size of the negative pattern region;
(3) using the negative photoresist developing device to develop the negative photoresist layer with developer for negative photoresist to remove the negative photoresist outside the negative pattern region;
(4) using the interlayer developing and etching device to develop the interlayer with developer for interlayer, or etch the interlayer with a pattern of the developed negative photoresist layer as an anti-etching mask, so that the pattern of the interlayer matches pattern of the developed negative photoresist layer; and
(5) using the positive photoresist developing device to develop the positive photoresist layer with developer for positive photoresist to remove the positive photoresist at an edge portion of the positive pattern region, thereby providing an exposed region associated with a size of the positive pattern region and a size of the negative pattern region, to expose the substrate.

The present invention further provides a method of controlling a photolithography system for controlling the steps performed by the photolithography system of the fourth, fifth or sixth aspect described above.

The present invention further provides a computer device comprising a memory, a processor, and computer program that is stored in the memory and can run on the processor, characterized in that the processor implements the method of controlling a photolithography system described above when executing the computer program.

The present invention further provides a computer readable medium having computer program stored thereon, which when executed by a processor implements the method of controlling photolithography system described above.

### Technical effect

The present invention has the following advantages over prior arts:
(1) The present invention has the characteristics of high efficiency, low cost, and easy operation, realizes miniaturization of the size of the original mask pattern, and can realize a line width by pattern contouring small than that of the conventional technique;
(2) the present invention, by coating the interlayer film between the two layers of photoresist, can also avoid or reduce the phenomenon that the two layers of photoresist dissolve during the coating process.

### DESCRIPTION OF FIGURES

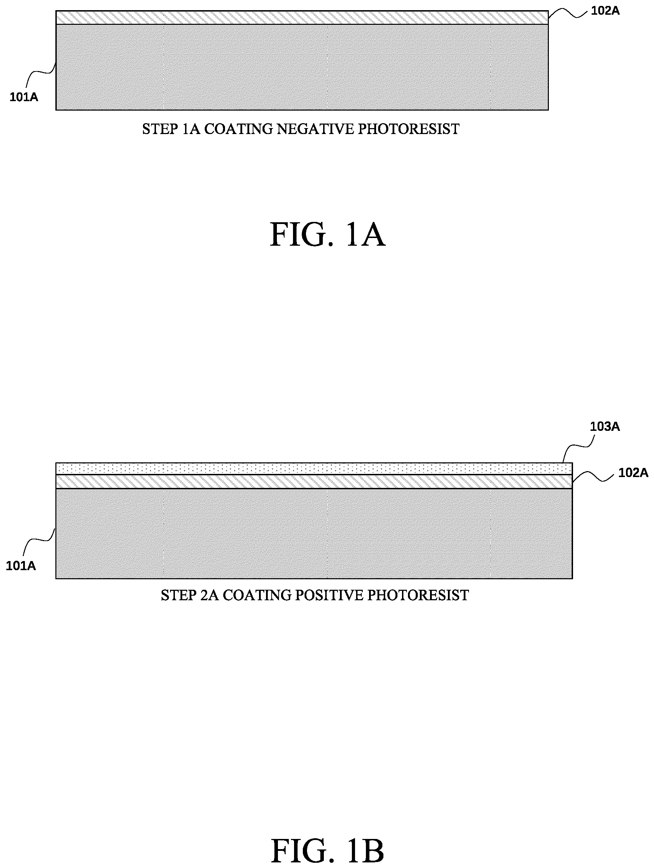

FIG. 1A is a schematic diagram showing step 1A of coating a negative photoresist on a substrate in the photolithography method according to Embodiment 1 of the present invention.
FIG. 1B is a schematic diagram showing step 2A of coating a positive photoresist on the negative photoresist in the photolithography method according to Embodiment 1 of the present invention.

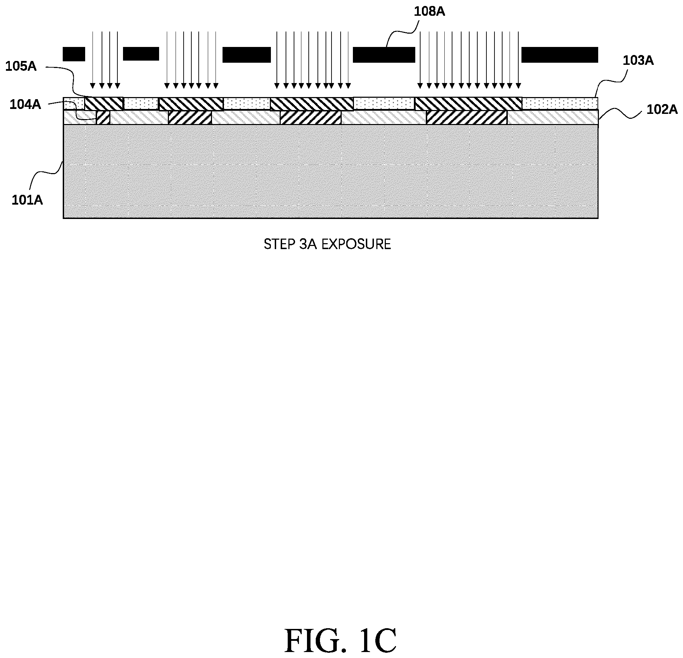

FIG. 1C is a schematic diagram showing step 3A of exposing two layers of photoresist in the photolithography method according to Embodiment 1 of the present invention.

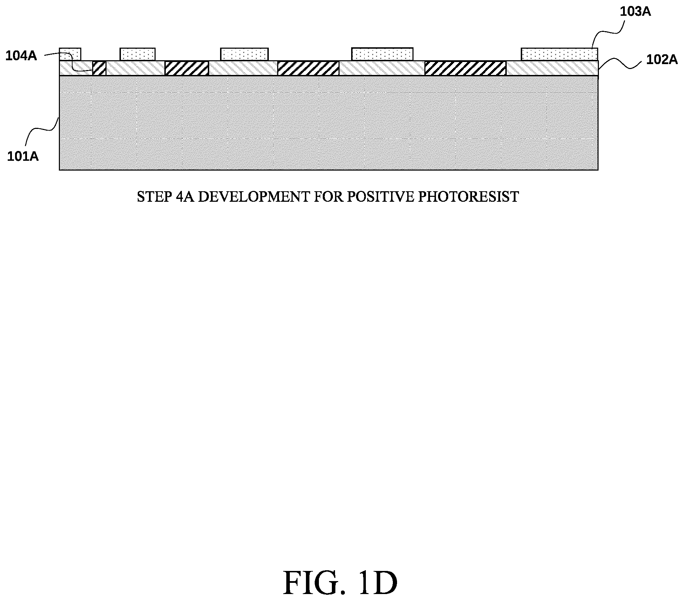

FIG. 1D is a schematic diagram showing step 4A of developing the positive photoresist in the photolithography method according to Embodiment 1 of the present invention.

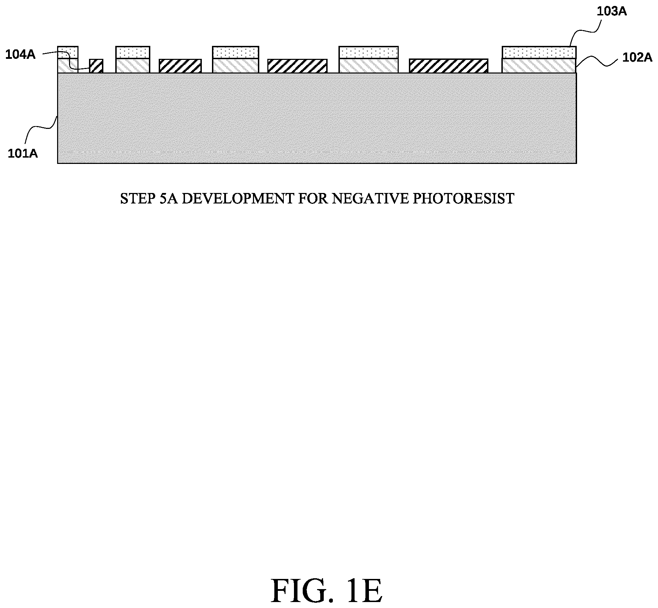

FIG. 1E is a schematic diagram showing step 5A of developing the negative photoresist in the photolithography method according to Embodiment 1 of the present invention.

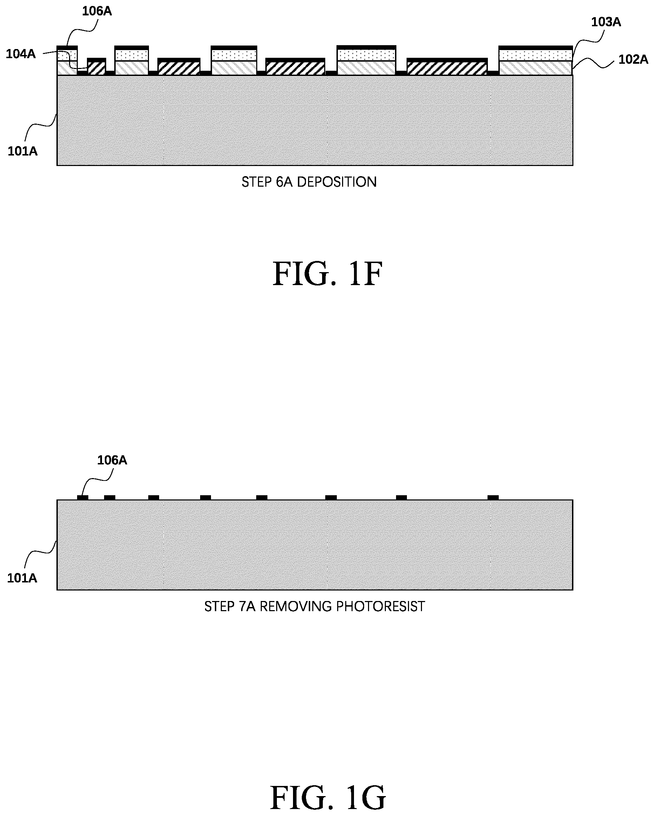

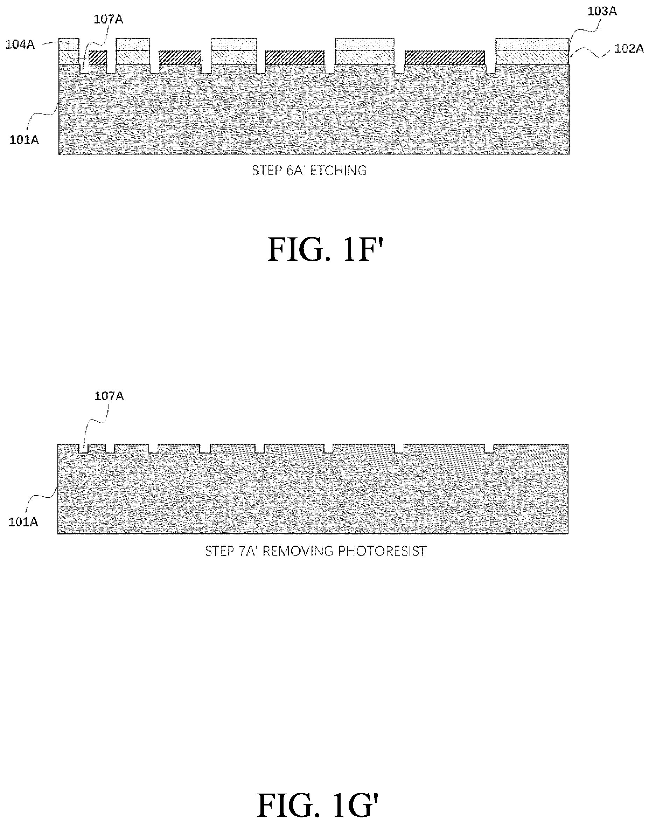

FIG. 1F is a schematic diagram showing step 6A of deposition by a deposition technique in the photolithography method according to Embodiment 1 of the present invention.
FIG. 1G is a schematic diagram showing step 7A of removing photoresist after deposition in the photolithography method according to Embodiment 1 of the present invention.
FIG. 1F' is a schematic diagram showing step 6A' of etching by etching technique in the photolithography method according to Embodiment 1 of the present invention.
FIG. 1G' is a schematic diagram showing step 7A' of removing photoresist after etching in the photolithography method according to Embodiment 1 of the present invention.
FIG. 2A is a schematic diagram showing step 1B of coating a negative photoresist on a substrate in the photolithography method according to Embodiment 2 of the present invention.
FIG. 2B is a schematic diagram showing step 2B of coating an interlayer on the negative photoresist in the photolithography method according to Embodiment 2 of the present invention.
FIG. 2C is a schematic diagram showing step 3B of coating a positive photoresist on the interlayer in the photolithography method according to Embodiment 2 of the present invention.
FIG. 2D is a schematic diagram showing step 4B of exposing two layers of photoresist in the photolithography method according to Embodiment 2 of the present invention.
FIG. 2E is a schematic diagram showing step 5B of developing the positive photoresist in the photolithography method according to Embodiment 2 of the present invention.
FIG. 2F is a schematic diagram showing step 6B of patterning the interlayer in the photolithography method according to Embodiment 2 of the present invention.
FIG. 2G is a schematic diagram showing step 7B of developing the negative photoresist in the photolithography method according to Embodiment 2 of the present invention.
FIG. 2H is a schematic diagram showing step 8B of deposition by a deposition technique in the photolithography method according to Embodiment 2 of the present invention.
FIG. 2I is a schematic diagram showing step 9B of removing photoresist after deposition in the photolithography method according to Embodiment 2 of the present invention.

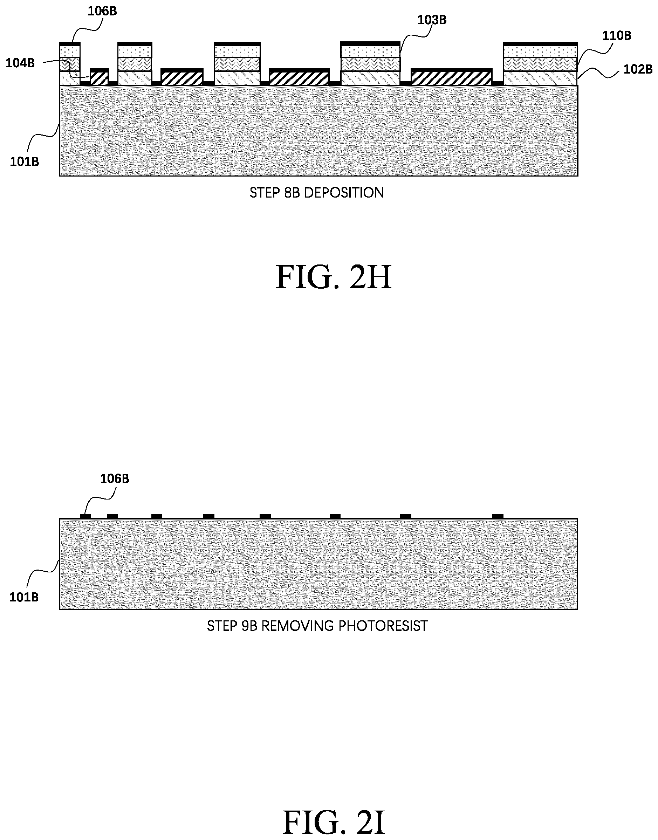

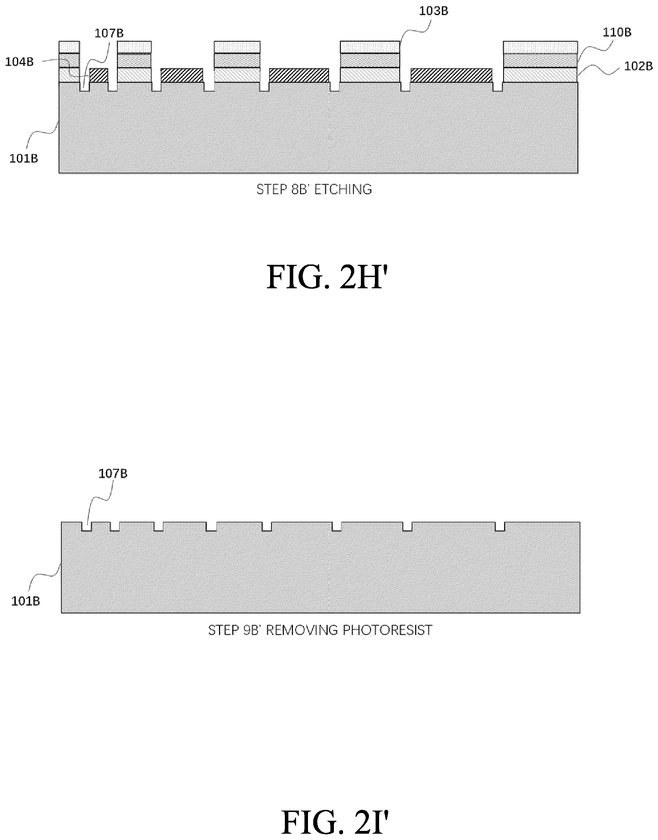

FIG. 2H' is a schematic diagram showing step 8B' of etching by etching technique in the photolithography method according to Embodiment 2 of the present invention.
FIG. 2I' is a schematic diagram showing step 9B' of removing photoresist after etching in the photolithography method according to Embodiment 2 of the present invention.

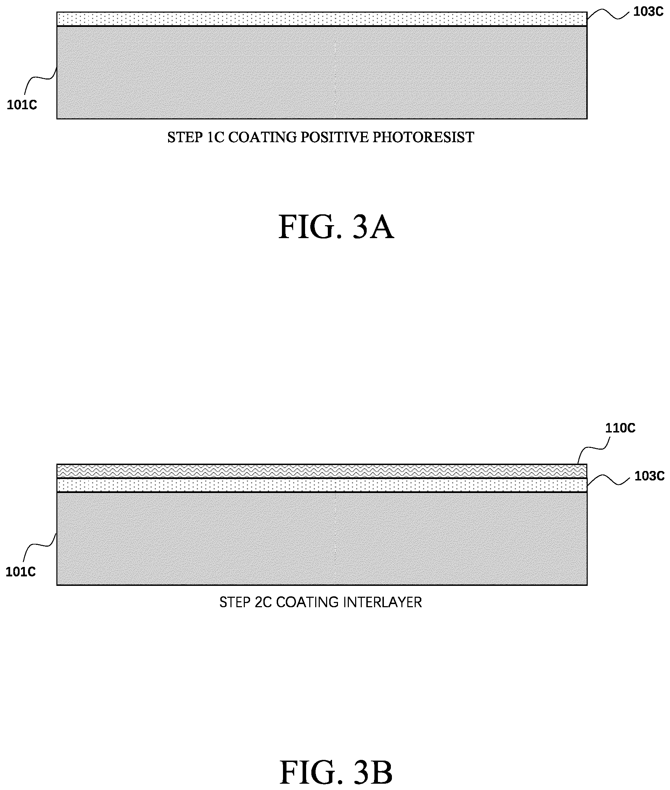

FIG. 3A is a schematic diagram showing step 1C of coating a positive photoresist on a substrate in the photolithography method according to Embodiment 3 of the present invention.
FIG. 3B is a schematic diagram showing step 2C of coating an interlayer on the positive photoresist in the photolithography method according to Embodiment 3 of the present invention.

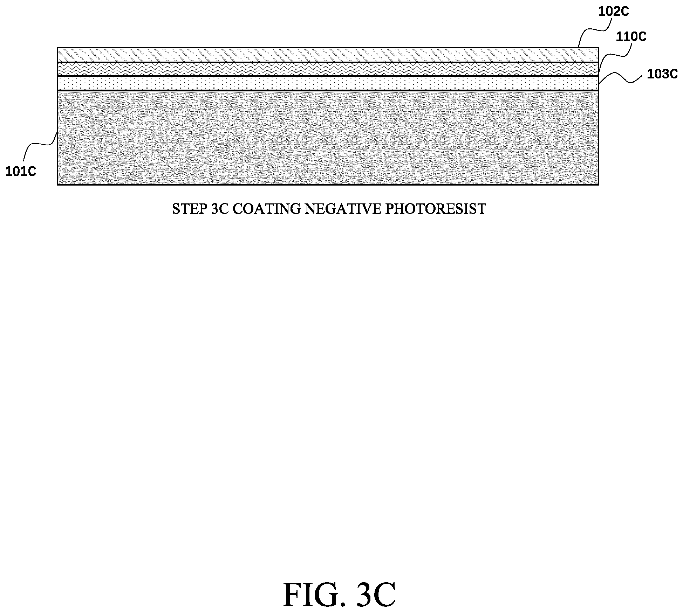

FIG. 3C is a schematic diagram showing step 3C of coating a negative photoresist on the interlayer in the photolithography method according to Embodiment 3 of the present invention.

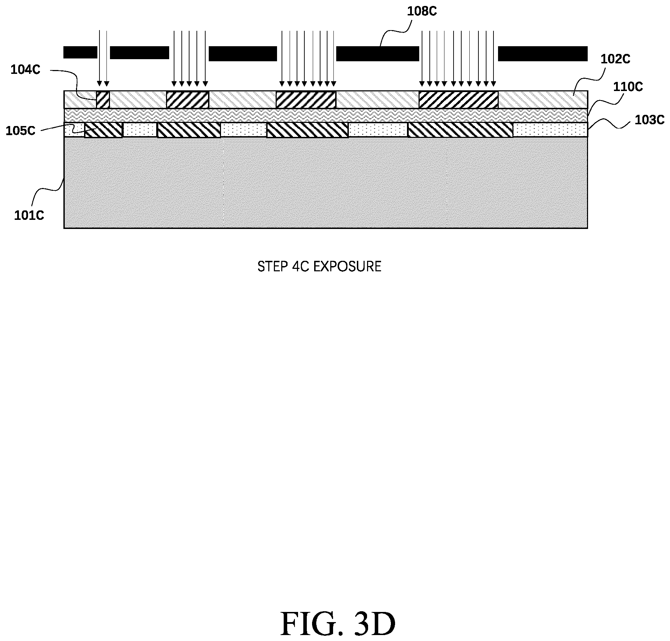

FIG. 3D is a schematic diagram showing step 4C of exposing two layers of photoresist in the photolithography method according to Embodiment 3 of the present invention.

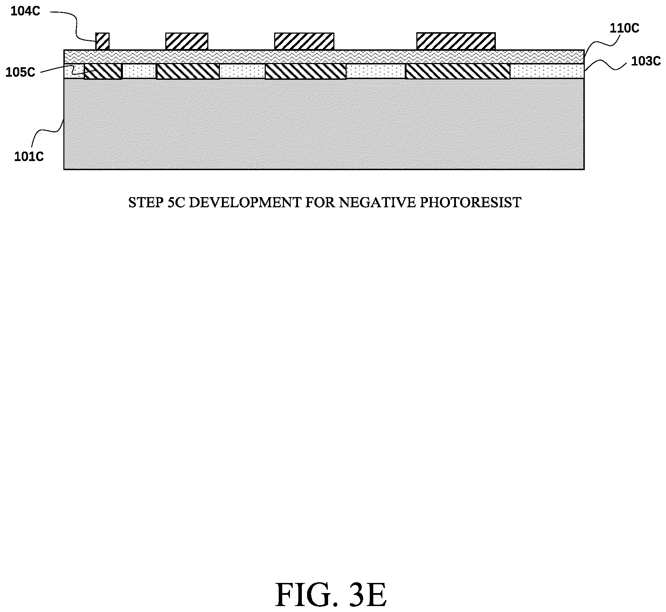

FIG. 3E is a schematic diagram showing step 5C of developing the negative photoresist in the photolithography method according to Embodiment 3 of the present invention.

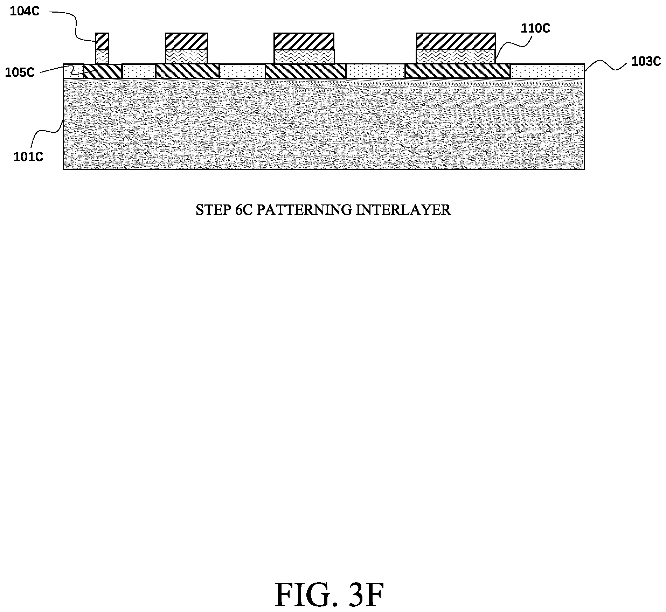

FIG. 3F is a schematic diagram showing step 6C of patterning the interlayer in the photolithography method according to Embodiment 3 of the present invention.

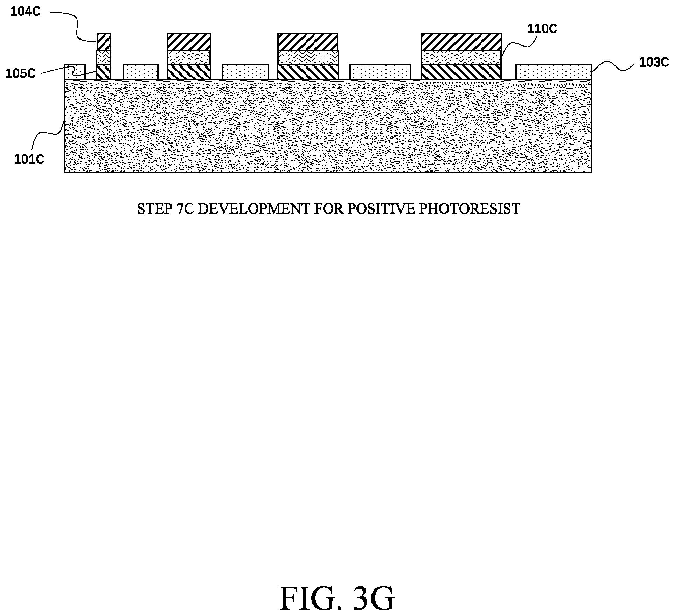

FIG. 3G is a schematic diagram showing step 7C of developing the positive photoresist in the photolithography method according to Embodiment 3 of the present invention.

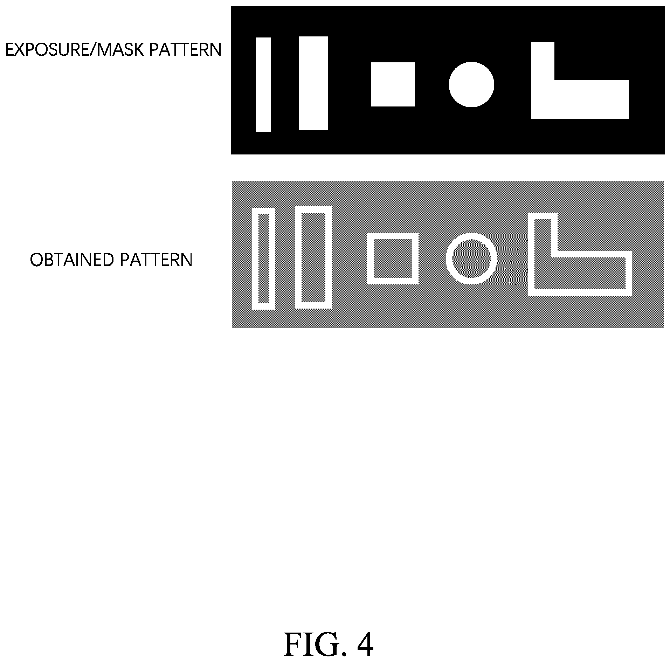

FIG. 4 is a schematic diagram showing a pattern of contour lines obtained on the basis of a mask pattern by the photolithography method according to an embodiment of the present invention.

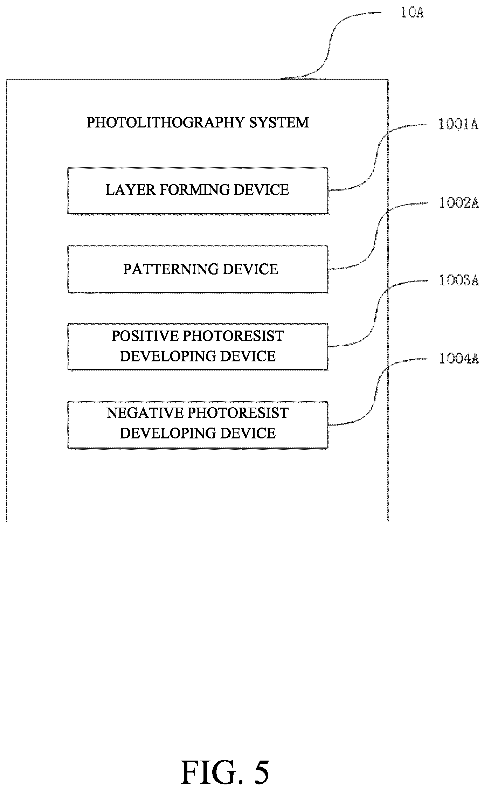

FIG. 5 is a block diagram schematically showing a photolithography system corresponding to the photolithography method according to Embodiment 1 of the present invention.

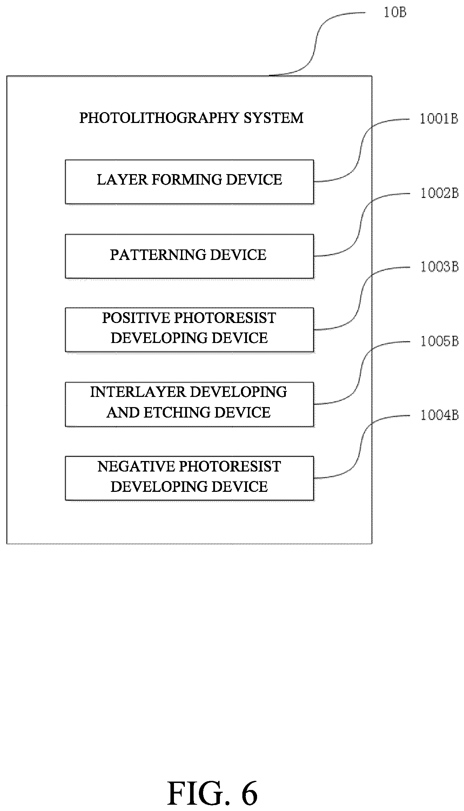

FIG. 6 is a block diagram schematically showing a photolithography system corresponding to the photolithography method according to Embodiment 2 of the present invention.

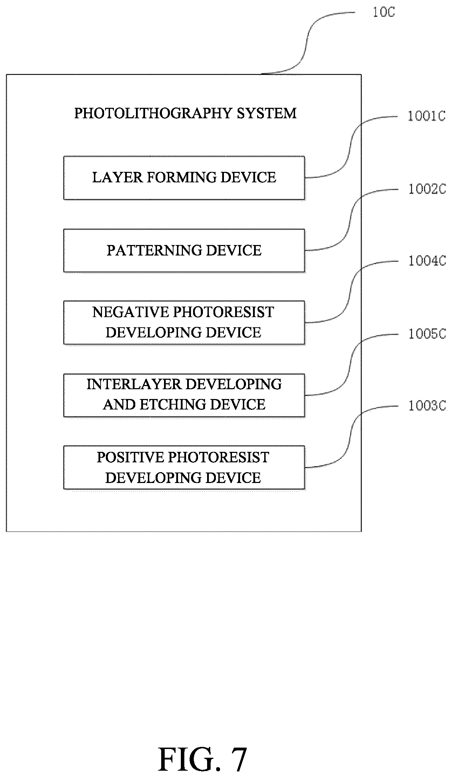

FIG. 7 is a block diagram schematically showing a photolithography system corresponding to the photolithography method according to Embodiment 3 of the present invention.

### Description of Reference Numbers

101A, 101B, 101C substrate
102A, 102B, 102C negative photoresist (negative photoresist layer)
103A, 103B, 103C positive photoresist (positive photoresist layer)
104A, 104B, 104C exposure pattern on negative photoresist (negative pattern region)
105A, 105B, 105C exposure pattern on positive photoresist (positive pattern region)
106A, 106B deposited layer
107A, 107B groove
108A, 108B, 108C lithography mask
110B, 110C interlayer
10A, 10B, 10C photolithography system
1001A, 1001B, 1001C layer forming device
1002A, 1002B, 1002C patterning device
1003A, 1003B, 1003C positive photoresist developing device
1004A, 1004B, 1004C negative photoresist developing device
1005B, 1005C interlayer developing and etching device

### DETAILED DESCRIPTION

Next, the present invention is described in detail with reference to the drawings and specific embodiments. The embodiments are implemented based on the premise of the technical solutions of the present invention. Detailed implementations and specific operational processes are provided, but the protective scopes of the present invention are not limited to the embodiments as described below.

For convenience of description, spatially relative terms, such as "below" "above", "under", "over", "on" etc., may be used herein to describe the relationship of one element or feature relative to another element or feature as shown. It should be understood that spatially relative terms are intended to include different directions of devices used or operated in addition to the directions shown in the figures. For example, if a device in the figure is flipped, an element described as "below" or "under" other element or feature will be oriented as "above" other element or feature.

Unless otherwise defined, terms used herein have the same meaning as commonly understood by one of ordinary skill in the art to which this invention belongs. Terms should be understood to have meanings consistent with those in the context of the related art and should not be understood as idealized or overformalized unless clearly so defined herein

### Embodiment 1

### <Photolithography Method Based on Bilayer Photoresist>

Embodiment 1 of the present invention provides a photolithography method comprising steps of:
(1) forming a negative photoresist layer on a substrate using a negative photoresist, and forming a positive photoresist layer on the negative photoresist layer using a positive photoresist;
(2) patterning the negative photoresist layer and the positive photoresist layer to form a positive pattern region and a negative pattern region on the positive photoresist layer and the negative photoresist layer, respectively, wherein a size the positive pattern region is larger than a size the negative pattern region;
(3) developing the positive photoresist layer with developer for positive photoresist to remove the positive photoresist in the positive pattern region; and
(4) developing the negative photoresist layer with developer for negative photoresist to remove the negative photoresist located near the negative pattern region, thereby providing an exposed region associated with the size of the positive pattern region and the size of the negative pattern region, to expose the substrate.

Hereinafter, Embodiment 1 of the above-described photolithography method based on a bilayer photoresist will be described in detail with reference to FIGS. 1A, 1B, 1C, 1D, 1E, 1F, 1G, 1F', and 1G'. In the drawings, the same or equivalent parts are denoted by the same reference numerals.

FIG. 1A is a schematic diagram showing step 1A of coating a negative photoresist on a substrate in the photolithography method according to Embodiment 1 of the present invention. FIG. 1B is a schematic diagram showing step 2A of coating a positive photoresist on the negative photoresist in the photolithography method according to Embodiment 1 of the present invention.

First, as shown in FIG. 1A, in step 1A, a layer of negative photoresist 102A (i.e., negative photoresist layer) is spin-coated on a substrate 101A and dried. Then, as shown in FIG. 1B, in step 2A, a layer of positive photoresist 103A (i.e., a positive photoresist layer) is spin-coated on the negative photoresist 102A and dried (corresponding to forming a negative photoresist layer on the substrate using a negative photoresist and forming a positive photoresist layer on the negative photoresist layer using a positive photoresist).

The negative photoresist includes negative ultraviolet photoresist, negative deep ultraviolet photoresist, negative extreme ultraviolet photoresist, negative electron beam photoresist, negative ion beam photoresist or negative X-ray photoresist, including but not limited to NANO^{™} SU-8 Series, HSQ, photoresist of AZ series (e.g., AZ N4000, AZ N6000), photoresist of HNR series, photoresist of SC series, photoresist of ma-N series (e.g., ma-N 400, ma-N 1400), AZ^{®} nLOF^{®} 2000 Series, AZ^{®} nLOF^{®} 5500 Photoresist, NR7-PY Series, NR9-PY Series, JSR WPR Series, NR71 Series NR9 Series, etc.

The positive photoresist includes positive ultraviolet photoresist, positive deep ultraviolet photoresist, positive extreme ultraviolet photoresist, positive electron beam photoresist, positive ion beam photoresist or positive X-ray photoresist, including but not limited to photoresist of MICROPOSIT S1800 series, BCI-3511 photoresist, photoresist of AZ series (e.g., AZ111, AZ 1500, AZ 3300, AZ 4999, AZ 6600, AZ 8112, AZ 3000, AZ 1075, AZ 700, AZ 900), photoresist of HNR 500 series, photoresist of OiR series, photoresist of TDMR-AR80 HP 6CP, PR1 series, photoresist of ma-P 1200 series, photoresist of SPR series (e.g., SPR 220, SPR 660, SPR3000 etc.), photoresist of PMMA series, etc.

In addition, the degree of matching for positive and negative photoresists of different Item No. needs to be confirmed in advance. Two paired groups of positive and negative photoresists are provided as follows. First group: positive photoresist of Item No. HTI 751 and negative photoresist of Item No. SUN 9i; second group: positive photoresist of Item No. AZ 1500 and negative photoresist of Item No. AZ nlof 2020.

As an example, the process of spin coating the negative photoresist (taking SUN 9i, AZ nlof 2020 as examples) is as follows: first spin coating the negative photoresist at a rotation speed of 800-1000 rotations/minute for 5-10 seconds (this step can be omitted); then spin coating the negative photoresist at a rotation speed of 4000-8000 rotations/minute for 30-40 seconds and baking the same at 95-100°C for 60-90 seconds.

As an example, the process of spin coating the positive photoresist (taking HTI 751, AZ 1500 as examples) is as follows: first spin coating the positive photoresist at a rotation speed of 800-1000 rotations/minute for 5-10 seconds (this step can be omitted); then spin coating the positive photoresist at a rotation speed of 2000-5000 rotations/minute for 30-40 seconds and baking the same at 90-100°C for 30-50 seconds.

In addition, different rotation speeds determine the thickness of the film of photoresists. Pre-bake temperature and time and subsequent exposure amount, exposure time and developing time are adjusted according to different thickness of films.

In addition, the material of the substrate includes semiconductor, metal, insulator, polymer or composite material.

FIG. 1C is a schematic diagram showing step 3A of exposing two layers of photoresist in the photolithography method according to Embodiment 1 of the present invention.

Subsequent to step 2A, as shown in FIG. 1C, in step 3A, the two layers of photoresist 102A, 103A are exposed under an exposure source using a lithographic mask with a template pattern or by focused direct writing (an example of a lithographic mask 108A is shown in FIG. 1C). After exposure, exposure patterns 104A, 105A (i.e., negative pattern region, positive pattern region) of different sizes are formed on the negative photoresist 102A and the positive photoresist 103A, respectively, and then the negative photoresist 102A and the positive photoresist 103A are dried (corresponding to patterning the negative photoresist layer and the positive photoresist layer to form a positive pattern region and a negative pattern region on the positive photoresist layer and the negative photoresist layer, respectively, wherein a size of the positive pattern region is larger than a size of the negative pattern region).

The exposure source includes ultraviolet light source, deep ultraviolet light source, extreme ultraviolet light source, ion beam, electron beam or X-ray. As an example, the wavelength of the exposure source may be 1 -500 nm, and the temperature for the drying after the exposure may be 30 -300°C. Further, the wavelength of the exposure source may be 350 -400 nm, and the temperature for the drying after the exposure may be 95 -105°C.

Focused direct writing includes ultraviolet direct writing, deep ultraviolet direct writing, extreme ultraviolet direct writing, ion beam direct writing, electron beam direct writing or X-ray direct writing. As an example, the feature line width or feature dimension of mask pattern may be 2 nm -1000 µm. Further, the feature line width or feature dimension of mask pattern may be 2 nm -1 µm.

As an example, the pre-baked silicon wafer as a substrate is fixed under the mask, and then placed under the ultraviolet light source, and the ultraviolet light source is turned on to perform photolithography. The exposure time is adjusted according to the paired group of positive and negative photoresists that are used. Taking the pairing mentioned above as example, the exposure flux of 100-200 mJ/cm² at the wavelength of 350-400 nm is applicable to the paired photoresist group of **HTI** 751 and SUN 9i, or the paired photoresist group of AZ 1500 and AZ nlof 2020. The absorption effect of positive photoresists (e.g., **HTI** 751, AZ 1500) of different thickness on ultraviolet radiation shall be taken into account for use of wavelength of UV and exposure flux to ensure that the underlying negative photoresist (e.g., SUN 9i, AZ nlof 2020) can obtain sufficient exposure flux. As the responses of the paired group of **HTI** 751 and SUN 9i and the paired group of AZ 1500 and AZ nlof 2020 to the exposure flux at specific wavelengths are different, patterns of different sizes based on the mask patterns (e.g., 104A, 105A in FIG. 1C) can be obtained.

As an example, the exposure may be in the form of single exposure. As an example, the exposure may be in the form of multiple exposures. That is, the exposure can be implemented by being divided to a plurality of exposures of a plurality of shorter periods of time or a plurality of exposures of smaller doses.

FIG. 1D is a schematic diagram showing step 4A of developing the positive photoresist in the photolithography method according to Embodiment 1 of the present invention. FIG. 1E is a schematic diagram showing step 5A of developing the negative photoresist in the photolithography method according to Embodiment 1 of the present invention.

Subsequent to step 3A, as shown in FIG. 1D, in Step 4A, a positive photoresist is developed with developer for positive photoresist (corresponding to developing the positive photoresist layer with developer for positive photoresist to remove the positive photoresist in the positive pattern region). Then, as shown in FIG. 1E, in step 5A, the negative photoresist is controllably developed with developer for negative photoresist to merely clean away the edge portion of the exposed pattern 104A on the negative photoresist and expose the material of the substrate, so as to transform the mask pattern to pattern of contour lines (corresponding to developing the negative photoresist layer with developer for negative photoresist to remove the negative photoresist located near the negative pattern region, thereby providing an exposed region associated with the size of the positive pattern region and the size of the negative pattern region, to expose the substrate).

The developer for positive photoresist is a developer corresponding to the positive photoresist, and the developer for negative photoresist is a developer corresponding to the negative photoresist. For example, the developer for positive photoresist may be TMAH 2.38%, MF-26A, and the developer for negative photoresist may be TMAH 2.38%, SU-8 developer, etc.

As an example, the exposed silicon wafer is placed in a corresponding developer for the positive photoresist, such as a TMAH developer, and the exposed positive photoresist on the silicon wafer is cleaned away, thereby generating a pattern complementary to the exposure pattern. Then the silicon wafer is cleaned to remove the developer, and dried to remove residual liquid. Thereafter, the exposed silicon wafer is placed in a corresponding developer for the negative photoresist, such as a TMAH developer, and the unexposed negative photoresist on the silicon wafer is partially (not completely) cleaned away by regulating the development time. Then the silicon wafer is cleaned to remove the developer and dried to remove the residual liquid, thereby generating a pattern of contour lines for the exposure pattern.

Further, if the developer for the positive photoresist and the developer for the negative photoresist are the same, for example, both are TMAH, steps 4A and 5A of the two-step development can be combined without additional steps of cleaning and drying in between. In addition, cross-experiments should be carried out on the positive photoresist and the negative photoresist and the corresponding developers to formulate the most appropriate development process.

FIG. 1F is a schematic diagram showing step 6A of deposition by a deposition technique in the photolithography method according to Embodiment 1 of the present invention. FIG. 1G is a schematic diagram showing step 7A of removing photoresist after deposition in the photolithography method according to Embodiment 1 of the present invention.

Subsequent to step 5A, as shown in FIG. 1F, in step 6A, a deposited layer 106A may be formed by a material deposition technique. Thereafter, as shown in FIG. 1G, in step 7A, the photoresist is removed, leaving pattern of contour lines.

The material deposition technique includes electrochemical deposition, electroplating, CVD deposition, laser sputtering, magnetron sputtering, thermal evaporation, electron beam evaporation or atomic deposition;
FIG. 1F' is a schematic diagram showing step 6A' of etching by etching technique in the photolithography method according to Embodiment 1 of the present invention. FIG. 1G' is a schematic diagram showing step 7A' of removing photoresist after etching in the photolithography method according to Embodiment 1 of the present invention.

Subsequent to step 5A, as shown in FIG. 1F', in step 6A, a groove 107A may be formed by an etching technique. Thereafter, as shown in FIG. 1G', in step 7A', the photoresist is removed, leaving pattern of contour lines.

FIG. 4 is a schematic diagram showing a pattern of contour lines obtained on the basis of a mask pattern by the photolithography method according to an embodiment of the present invention.

As shown in FIG. 4, by adopting Embodiment 1 of the present invention, it is possible to obtain pattern of contour lines based on a mask pattern whose line width is smaller than the line width of the mask pattern, so that the density of lines can be multiplied and miniaturization of the size of the original mask pattern can be realized. Further, in FIG. 4, examples in which the mask pattern includes a first rectangular shape, a second rectangular shape, a square shape, a circle shape, and an irregular pattern are shown from left to right, respectively, but the present invention is not limited thereto. A mask pattern of an arbitrary shape can be employed according to the need, so that pattern of contour lines of an arbitrary shape can be realized.

The specific embodiments of the photolithography method based on bilayer photoresist of the present invention are described in details below.

### (Embodiment 1a)

As an example, Embodiment 1a specifically includes the steps of:

### (1) coating negative photoresist

A silicon wafer is placed and fixed in a photoresist homogenizing system. The negative photoresist SUN 9i or AZ nlof 2020 is spin coated at 1000 rpm×5 s + 4000 rpm×40 s and then is dried at 100-100 °C for 60 seconds.

### (2) coating positive photoresist

The cooled silicon wafer is placed and fixed in the photoresist homogenizing system. The positive photoresist HTI 751 or AZ 1500 is spin-coated at 800 rpm×5 s + 2500 rpm×30 s and then is dried at 95-100 °C for 40 seconds.

### (3) exposure

The substrate of the silicon wafer which has undergone the above processes is tightly fixed under a mask, the chamber is vacuumized, the substrate is placed right under the ultraviolet light source, and the light source is turned on to perform photolithography. The exposure time is adjusted according to the kind of paired group of photoresist and the thickness of the layer of photoresist. After the exposure is finished, the mask is removed, the exposed silicon wafer is moved to a heating stage, and is baked at 100°C for 45 seconds. The exposure flux is e.g., 100 mJ/cm², which can be changed according to need.

### (4) development for positive photoresist

The exposed silicon wafer is placed in a corresponding developer for the positive photoresist, such as a TMAH developer, and the exposed positive photoresist on the silicon wafer is cleaned away, thereby generating a pattern complementary to the exposure pattern. Then the silicon wafer is cleaned to remove the developer, and is dried to remove residual liquid.

### (5) development for negative photoresist

The exposed silicon wafer is placed in a corresponding developer for the negative photoresist, such as a TMAH developer, and the unexposed negative photoresist on the silicon wafer is partially (not completely) cleaned away by regulating the development time. Then the silicon wafer is cleaned to remove the developer, and is dried to remove the residual liquid, thereby generating a pattern of contour lines based on the mask pattern.

Note that, if the developer for the positive photoresist and the developer for the negative photoresist are the same, for example, both are TMAH, steps (4) and (5) of the two-step development can be combined without additional steps of cleaning and drying in between.

In the present embodiment 1a, as an example, the following deposition process may be further performed in addition to the above steps (1) to (5):

### (6) deposition of materials

The silicon wafer that has been developed is placed in an evaporation coater, the chamber is vacuumized by a molecular pump to 10⁻⁶ Pa, and a chromium film of 2 nm and a gold film of 50 nm are thermally evaporated at rates of 1 Å/s and 0.5 Å/s, respectively. The chromium film of 2 nm is used as an adhesion layer for the gold film.

### (7) removing the photoresist.

After the chamber is cooled, vacuum is broken in the chamber and the coated silicon wafer is taken out. The silicon wafer is immersed in the acetone, is untrasonically cleaned until the photoresist is completely removed, leaving patterns of contour lines for gold.

In the present embodiment 1a, as an example, the following etching process may be further performed in addition to the above steps (1) to (5):

### (6') dry etching

The silicon wafer after photolithography is placed in an ion etching machine, and the exposed silicon substrate is etched by plasma gas using the pattern of photoresist as a mask, so that the pattern can be etched onto the silicon wafer at the pattern of contour lines.

### (7') removing the photoresist

The silicon wafer is immersed in acetone and is ultrasonically cleaned until the photoresist is completely removed, thereby preparing a pattern of contour lines on the surface of the silicon wafer.

### (Embodiment 1b)

Regarding exposure, Embodiment 1a use such a way of exposure in which the substrate of the silicon wafer is tightly fixed under the mask, the chamber is vacuumized and the substrate is placed right under the ultraviolet light source, but the present invention is not limited thereto. For example, the photolithography technology based on bilayer of photoresist of positive and negative photoresists of the present invention can also use projection exposure. Hereinafter, in the present embodiment 1b, the exposure step of the positive and negative bi-layer photoresist lithography technique of the present invention is described by taking a projection ultraviolet lithography system having a wavelength of ultraviolet light less than 400 nm as an example (as the remaining steps are similar to those of the embodiment 1a, only the exposure step (3) is described here, while repetitive description of the remaining steps is omitted).

### (3) projection ultraviolet exposure

The substrate of the silicon wafer that has undergone the above steps is tightly fixed on a sample stage of a photolithography machine, and the projection ultraviolet exposure is performed through a mask for photolithography. The exposure time is adjusted according to the kind of paired group of photoresist and the thickness of the layer of photoresist. After the exposure is finished, the exposed silicon wafer is moved to a heating stage, and is baked at 110°C for 90 seconds. The exposure flux is e.g., 100 mJ/cm², which can be changed according to need.

### (Embodiment 1c)

Regarding exposure, Embodiment 1a use such a way of exposure in which the substrate of the silicon wafer is tightly fixed under the mask, the chamber is vacuumized and the silicon wafer is placed right under the ultraviolet light source, and Embodiment 1b uses the way of projection exposure, but the present invention is not limited thereto. For example, the photolithography technology based on bilayer of photoresist of positive and negative photoresists of the present invention can also use ultraviolet direct writing exposure. Hereinafter, in the present embodiment 1c, the exposure step of the positive and negative bi-layer photoresist lithography technique of the present invention using the ultraviolet direct writing exposure is described (as the remaining steps are similar to those of the embodiment 1a, only the exposure step (3) is described here, while repetitive description of the remaining steps is omitted).

### (3) ultraviolet direct writing exposure

The substrate of the silicon wafer that has undergone the above steps is tightly fixed under the source of exposure, the ultraviolet direct writing system is turned on to perform direct writing exposure. The exposure time is adjusted according to the kind of paired group of photoresist and the thickness of the layer of photoresist. After the exposure is finished, the mask is removed, the exposed silicon wafer is moved to a heating stage, and is baked at 110°C for 60 seconds. The exposure flux is e.g., 100 mJ/cm², which can be changed according to need.

### (Embodiment 1d)

Regarding exposure, Embodiment 1a use such a way of exposure in which the substrate of the silicon wafer is tightly fixed under the mask, the chamber is vacuumized and the silicon wafer is placed right under the ultraviolet light source, Embodiment 1b uses the way of projection exposure, and Embodiment 1c uses the way of ultraviolet direct writing exposure, but the present invention is not limited thereto. For example, the photolithography technology based on bilayer of photoresist of positive and negative photoresists of the present invention can also use electron beam direct writing exposure. Described below, in Embodiment 1d, are the main steps of the photolithography technology based on bilayer photoresist of positive and negative photoresists using electron beam direct writing exposure of the present invention.

### (1) spin coating negative photoresist

The silicon wafer that has been cleaned is placed in a spin coater and is fixed in vacuum. The photoresist is spin coated by drop coating the negative electron beam photoresist HSQ, and is pre-dried.

### (2) spin coating positive photoresist

The silicon wafer that has been cooled is placed in a spin coater and is fixed in vacuum. The photoresist is spin coated by drop coating positive electron beam photoresist PMMA, and pre-dried.

### (3) electron beam direct writing exposure

The substrate of the silicon wafer that has undergone the above steps is placed in an electron beam direct writing system to perform electron beam direct writing. The exposure dose is adjusted according to the kind of paired group of photoresist and the thickness of the layer of photoresist. After the electron direct writing exposure is finished, the exposed silicon wafer is moved to a heating stage, and is post-dried. The exposure flux is e.g., 500 µC/cm², which can be changed according to needs.

### (4) development for positive photoresist

After post-drying is finished and the silicon wafer has been cooled to room temperature, developments are performed respectively. The process is as follows: placing the silicon wafer after photolithography in developer for positive electron beam photoresist (MIBK:IPA developer) to cause the exposed positive photoresist on the silicon wafer to be cleaned away; then taking out the silicon wafer, cleaning it with water, and drying it with a flow of nitrogen.

### (5) development for negative photoresist

The silicon wafer is placed in developer for negative electron beam photoresist (TMAH developer) again, partly removing the unexposed negative photoresist PMMA under the unexposed positive photoresist; then the silicon wafer is taken out, is cleaned with water, and is dried with a flow of nitrogen. The pattern of contour lines based on the mask pattern is prepared.

Subsequently, raised or recessed structures can implemented by further combining the steps of deposition of materials or dry/wet etching etc. Those steps are not repeated here because they are similar to the steps (6), (7) and the steps (6'), (7') in Embodiment 1a.

### Embodiment 2

### < Photolithography Method Based on Negative Photoresist + Interlayer Film + Positive Photoresist >

Embodiment 2 of the present invention provides a photolithography method based on negative photoresist + interlayer film + positive photoresist, comprising the steps of:
(1) forming a negative photoresist layer on a substrate using a negative photoresist, forming an interlayer on the negative photoresist layer and forming a positive photoresist layer on the interlayer using a positive photoresist;
(2) patterning the negative photoresist layer and the positive photoresist layer to form a positive pattern region and a negative pattern region on the positive photoresist layer and the negative photoresist layer, respectively, wherein a size of the positive pattern region is larger than a size of the negative pattern region;
(3) developing the positive photoresist layer with developer for positive photoresist to remove the positive photoresist in the positive pattern region;
(4) developing the interlayer with developer for interlayer, or etching the interlayer with a pattern of the developed positive photoresist layer as an anti-etching mask, so that the pattern of the interlayer matches pattern of the developed positive photoresist layer; and
(5) developing the negative photoresist layer with developer for negative photoresist to remove the negative photoresist located near the negative pattern region, thereby providing an exposed region associated with the size of the positive pattern region and the size of the negative pattern region, to expose the substrate.

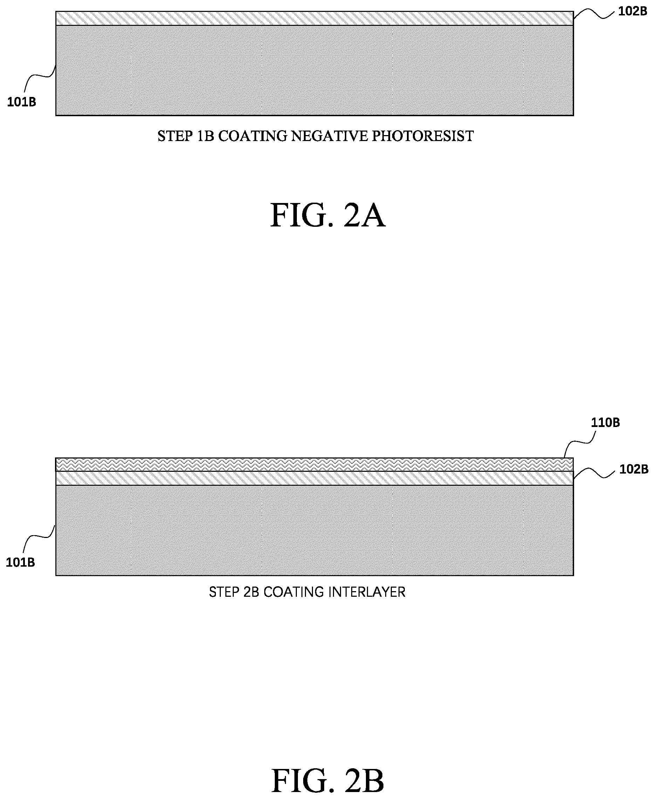

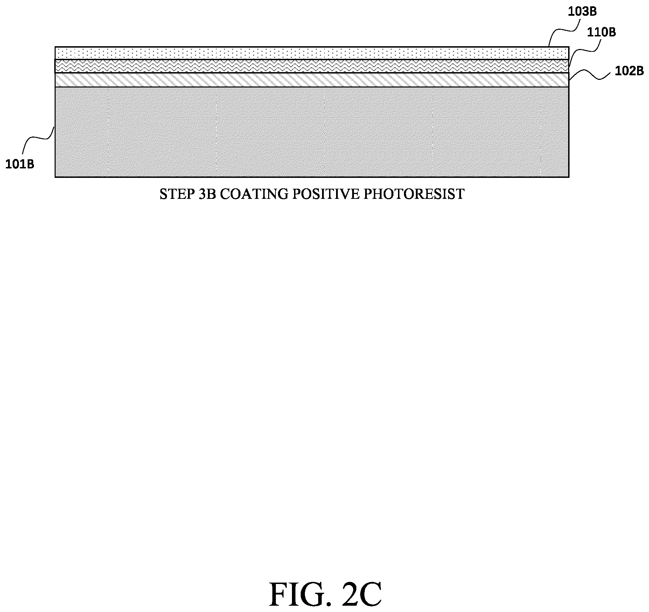

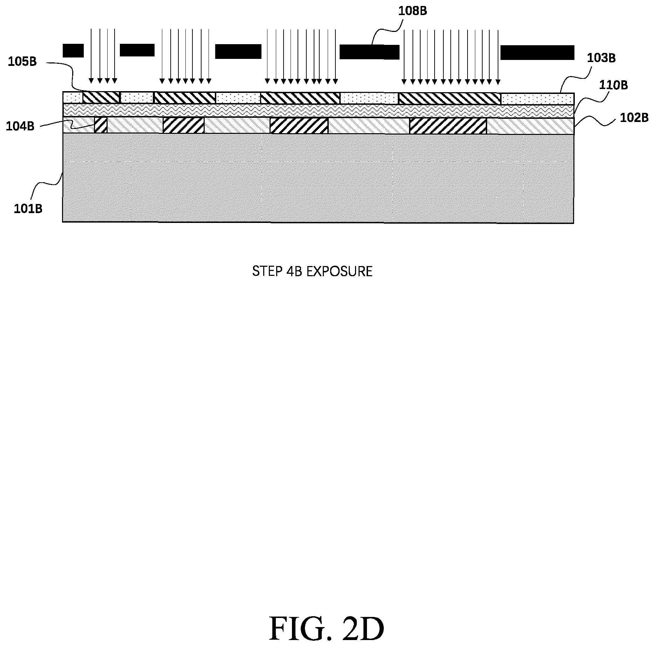

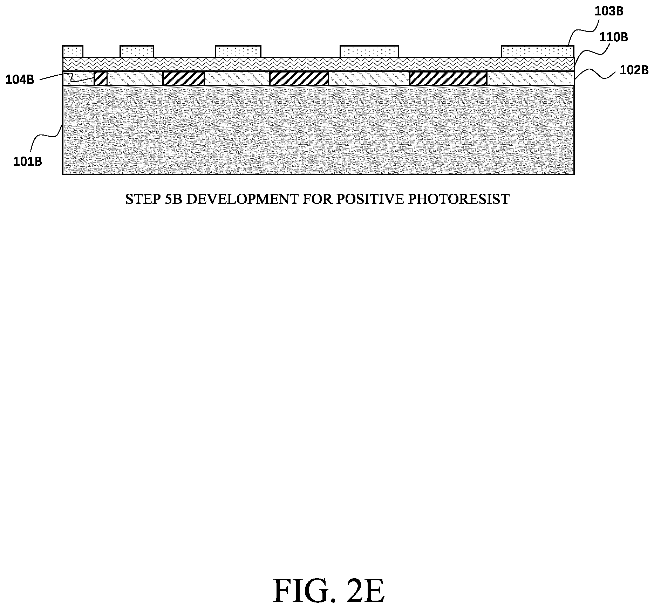

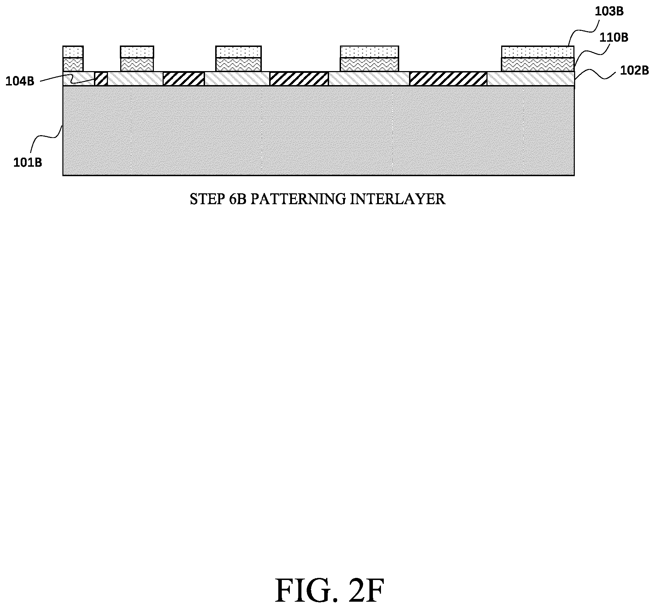

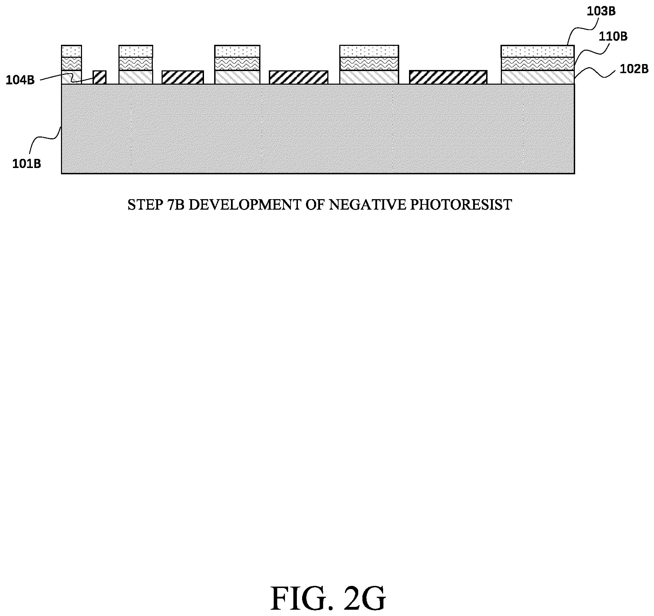

Hereinafter, Embodiment 2 of the above-described photolithography method based on negative photoresist + interlayer film + positive photoresist will be described in detail with reference to FIGS. 2A, 2B, 2C, 2D, 2E, 2F, 2G, 2H, 2I, 2H', and 2I'. In the drawings, the same or equivalent parts are denoted by the same reference numerals. Further, repetitive description of portions similar to those of Embodiment 1 in Embodiment 2 will be omitted.

FIG. 2A is a schematic diagram showing step 1B of coating a negative photoresist on a substrate in the photolithography method according to Embodiment 2 of the present invention. FIG. 2B is a schematic diagram showing step 2B of coating an interlayer on the negative photoresist in the photolithography method according to Embodiment 2 of the present invention. FIG. 2C is a schematic diagram showing step 3B of coating a positive photoresist on the interlayer in the photolithography method according to Embodiment 2 of the present invention.

First, as shown in FIG. 2A, in step 1B, a layer of negative photoresist 101B (i.e., negative photoresist layer) is spin-coated on a substrate 102B and is dried. Then, as shown in FIG. 2B, in step 2B, an interlayer film 110B is coated on the negative photoresist 102B. Then, as shown in FIG. 2C, in step 2C, a layer of positive photoresist 103B matching the negative photoresist 102B (i.e., a positive photoresist layer) is spin-coated on the interlayer film 110B and is dried (corresponding to forming a negative photoresist layer on a substrate using a negative photoresist, forming an interlayer on the negative photoresist layer and forming a positive photoresist layer on the interlayer using a positive photoresist).

The negative photoresist includes negative ultraviolet photoresist, negative deep ultraviolet photoresist, negative extreme ultraviolet photoresist, negative electron beam photoresist, negative ion beam photoresist or negative X-ray photoresist. The positive photoresist includes positive ultraviolet photoresist, positive deep ultraviolet photoresist, positive extreme ultraviolet photoresist, positive electron beam photoresist, positive ion beam photoresist or positive X-ray photoresist.

The degree of matching for positive and negative photoresists of different Item No. needs to be confirmed in advance. Two paired groups of positive and negative photoresists are provided as follows. First group: positive photoresist of Item No. HTI 751 and negative photoresist of Item No. SUN 9i; second group: positive photoresist of Item No. AZ 1500 and negative photoresist of Item No. AZ nlof 2020.

As an example, the process of spin coating the negative photoresist (taking SUN 9i, AZ nlof 2020 as examples) is as follows: first spin coating the negative photoresist at a rotation speed of 800-1000 rotations/minute for 5-10 seconds (this step can be omitted); then spin coating the negative photoresist at a rotation speed of 4000-8000 rotations/minute for 30-40 seconds and baking the same at 95-100°C for 60-90 seconds.

As an example, the process of spin coating the positive photoresist (taking HTI 751, AZ 1500 as examples) is as follows: first spin coating the positive photoresist at a rotation speed of 800-1000 rotations/minute for 5-10 seconds (this step can be omitted); then spin coating the positive photoresist at a rotation speed of 2000-5000 rotations/minute for 30-40 seconds and baking the same at 90-100°C for 30-50 seconds.

In addition, different rotation speeds determine the thickness of the film of photoresists. Pre-bake temperature and time and subsequent exposure amount, exposure time and developing time are adjusted according to different thickness of films.

In addition, the material of the substrate includes semiconductor, metal, insulator, polymer or composite material.

FIG. 2D is a schematic diagram showing step 4B of exposing two layers of photoresist in the photolithography method according to Embodiment 2 of the present invention.

Subsequent to step 3B, as shown in FIG. 2D, in step 4B, the two layers of photoresist 102B, 103B are exposed under an exposure source using a lithographic mask with a template pattern or by focused direct writing (an example of a lithographic mask 108B is shown in FIG. 2D). After exposure, exposure patterns 104B, 105B (i.e., negative pattern region, positive pattern region) of different sizes are formed on the negative photoresist 102B and the positive photoresist 103B, respectively, and then the negative photoresist 102B and the positive photoresist 103B are dried (corresponding to patterning the negative photoresist layer and the positive photoresist layer to form a positive pattern region and a negative pattern region on the positive photoresist layer and the negative photoresist layer, respectively, wherein a size of the positive pattern region is larger than a size of the negative pattern region).

The exposure source includes ultraviolet light source, deep ultraviolet light source, extreme ultraviolet light source, ion beam, electron beam or X-ray. Focused direct writing includes ultraviolet direct writing, deep ultraviolet direct writing, extreme ultraviolet direct writing, ion beam direct writing, electron beam direct writing or X-ray direct writing. The feature line width or feature dimension of the mask patterns is 2 nm-1000 µm.

As an example, the pre-baked silicon wafer as a substrate is fixed under the mask, and is then placed under the ultraviolet light source, and the ultraviolet light source is turned on to perform photolithography. The exposure time is adjusted according to the paired group of positive and negative photoresists that are used. Taking the pairing mentioned above as an example, the exposure flux of 100-200 mJ/cm² at the wavelength of 350-400 nm is applicable to the paired photoresist group of HTI 751 and SUN 9i, and the paired photoresist group of AZ 1500 and AZ nlof 2020. The absorption effect of positive photoresists (e.g., HTI 751, AZ 1500) of different thickness on ultraviolet radiation shall be taken into account for use of wavelength of UV and exposure flux to ensure that the underlying negative photoresist (e.g., SUN 9i, AZ nlof 2020) can obtain sufficient exposure flux. As the responses of the paired group of HTI 751 and SUN 9i and the paired group of AZ 1500 and AZ nlof 2020 to the exposure flux at specific wavelengths are different, patterns of different sizes based on the mask patterns (e.g., 104B, 105B in FIG. 2D) can be obtained.

As an example, the exposure may be in the form of single exposure. As an example, the exposure may be in the form of multiple exposures. That is, the exposure can be implemented by being divided to a plurality of exposures of a plurality of shorter periods of time or a plurality of exposures of smaller doses.

FIG. 2E is a schematic diagram showing step 5B of developing the positive photoresist in the photolithography method according to Embodiment 2 of the present invention. FIG. 2F is a schematic diagram showing step 6B of patterning the interlayer in the photolithography method according to Embodiment 2 of the present invention. FIG. 2G is a schematic diagram showing step 7B of developing the negative photoresist in the photolithography method according to Embodiment 2 of the present invention.

Subsequent to Step 4B, as shown in FIG. 2E, in Step 5B, a positive photoresist is developed with developer for positive photoresist (corresponding to developing the positive photoresist layer with developer for positive photoresist to remove the positive photoresist in the positive pattern region). Then, as shown in FIG. 2F, in step 6B, the interlayer film is developed with the developer for interlayer, or the interlayer film is etched with the pattern of the developed positive photoresist as an anti-etching mask, so that the pattern of the interlayer film matches the pattern of the developed positive photoresist (corresponding to developing the interlayer with developer for interlayer, or etching the interlayer with a pattern of the developed positive photoresist layer as an anti-etching mask, so that the pattern of the interlayer matches the pattern of the developed positive photoresist layer) Then, as shown in FIG. 2G, in step 7B, the negative photoresist is controllably developed with developer for negative photoresist to merely clean away the edge portion of the exposed pattern 104B on the negative photoresist and expose the material of the substrate, so as to transform the mask pattern to pattern of contour lines (corresponding to developing the negative photoresist layer with developer for negative photoresist to remove the negative photoresist located near the negative pattern region, thereby providing an exposed region associated with the size of the positive pattern region and the size the negative pattern region, to expose the substrate).

As an example, the exposed silicon wafer is placed in a corresponding developer for the positive photoresist, such as a TMAH developer, and the exposed positive photoresist on the silicon wafer is cleaned away, thereby generating a pattern complementary to the exposure pattern. Then the silicon wafer is cleaned to remove the developer, and is dried to remove residual liquid. Then, the exposed silicon wafer is placed in a corresponding developer for interlayer film, such as TMAH developer, or dry etching and the like is adopted, and the pattern of the positive photoresist is used as an anti-etching mask, so that the pattern of the positive photoresist is transferred to the underlying interlayer film Then the silicon wafer is cleaned and is dried according to the situation, so that the interlayer film obtains a pattern matching or close to the pattern of positive photoresist. Thereafter, the exposed silicon wafer is placed in a corresponding developer for the negative photoresist, such as a TMAH developer, and the unexposed negative photoresist on the silicon wafer is partially (not completely) cleaned away by regulating the development time. Then the silicon wafer is cleaned to remove the developer and is dried to remove the residual liquid, thereby obtaining a pattern of contour lines for the exposure pattern.

Further, if the developers for the positive photoresist, the negative photoresist, and the interlayer film are the same, or the developers for two of the positive photoresist, the negative photoresist, and the interlayer film are the same, the corresponding development steps can be combined according to the actual situation, so that the steps of cleaning and drying can be reduced. In addition, cross-experiments should be carried out on the positive photoresist, the negative photoresist and the interlayer film and the corresponding developers to formulate the most appropriate development process.

FIG. 2H is a schematic diagram showing step 8B of deposition by a deposition technique in the photolithography method according to Embodiment 2 of the present invention. FIG. 2I is a schematic diagram showing step 9B of removing photoresist after deposition in the photolithography method according to Embodiment 2 of the present invention.

Subsequent to step 7B, as shown in FIG. 2H, in step 8B, a deposited layer 106B may be formed by a material deposition technique. Thereafter, as shown in FIG. 2I, in step 9B, the photoresist is removed, leaving pattern of contour lines.

The material deposition technique includes electrochemical deposition, electroplating, CVD deposition, laser sputtering, magnetron sputtering, thermal evaporation, electron beam evaporation or atomic deposition;
FIG. 2H' is a schematic diagram showing step 8B' of etching by etching technique in the photolithography method according to Embodiment 2 of the present invention. FIG. 2I' is a schematic diagram showing step 9B' of removing photoresist after etching in the photolithography method according to Embodiment 2 of the present invention.

Subsequent to step 7B, as shown in FIG. 2H', in step 8B', a groove 107B may be formed by an etching technique. Thereafter, as shown in FIG. 2I', in step 9B', the photoresist is removed, leaving pattern of contour lines.

As shown in FIG. 4, by adopting Embodiment 2 of the present invention, it is possible to obtain pattern of contour lines based on a mask pattern whose line width is smaller than the line width of the mask pattern, so that the density of lines can be multiplied and miniaturization of the size of the original mask pattern can be realized. Furthermore, by coating the interlayer film between the two layers of the photoresist, it is also possible to avoid or reduce the phenomenon that the two layers of the photoresist dissolve during the coating process.

### (Embodiment 2a)

As an example, Embodiment 2a specifically includes the steps of:

### (1) coating negative photoresist

A silicon wafer is placed and fixed in the photoresist homogenizing system. The negative photoresist SUN 9i or AZ nlof 2020 is spin coated at 1000 rpm×5 s + 4000 rpm×40 s and then is dried at 100-100 °C for 60 seconds.

### (2) coating interlayer film

The silicon wafer is placed into a coating system for interlayer film (vapor phase coating, scraping coating, spraying or spin coating, etc.) to perform coating of interlayer film. The interlayer film comprises an inorganic substance, a polymer, or a composite material. The function of interlayer is to avoid or reduce the phenomenon that the two layers of the photoresist dissolve during the coating process.

### (3) coating positive photoresist

The cooled silicon wafer is placed and fixed in the photoresist homogenizing system. The positive photoresist HTI 751 or AZ 1500 is spin-coated at 800 rpm×5 s + 2500 rpm×30 s and then is dried at 95-100 °C for 40 seconds.

### (4) exposure

The substrate of the silicon wafer which has undergone the above process is tightly fixed under a mask, the chamber is vacuumized, the substrate is placed right under the ultraviolet light source, and the light source is turned on to perform photolithography. The exposure time is adjusted according to the kind of paired group of photoresist and the thickness of the layer of photoresist. After the exposure is finished, the mask is removed, the exposed silicon wafer is moved to a heating stage, and is baked at 100°C for 45 seconds. The exposure flux is e.g., 100 mJ/cm², which can be changed according to need.

### (5) development for positive photoresist

The exposed silicon wafer is placed in a corresponding developer for the positive photoresist, such as a TMAH developer, and the exposed positive photoresist on the silicon wafer is cleaned away, thereby generating a pattern complementary to the exposure pattern. Then the silicon wafer is cleaned to remove the developer, and is dried to remove residual liquid.

### (6) patterning of interlayer file

The exposed silicon wafer is placed in a corresponding developer for interlayer film, such as TMAH developer, or dry etching and the like is adopted, and the pattern of the positive photoresist is used as an anti-etching mask, so that the pattern of the positive photoresist is transferred to the underlying interlayer film. Then the silicon wafer is cleaned and dried according to the situation, so that the interlayer film obtains a pattern matching or close to the pattern of positive photoresist.

### (7) development for negative photoresist

The exposed silicon wafer is placed in a corresponding developer for the negative photoresist, such as a TMAH developer, and the unexposed negative photoresist on the silicon wafer is partially (not completely) cleaned away by regulating the development time. Then the silicon wafer is cleaned to remove the developer and is dried to remove the residual liquid, thereby generating a pattern of contour lines based on the mask pattern.

Note that, if the developers for the positive photoresist, the negative photoresist, and the interlayer film are the same, or the developers for two of the positive photoresist, the negative photoresist, and the interlayer film are the same, the corresponding development steps can be combined according to the actual situation, so that the steps of cleaning and drying can be reduced

In the present embodiment 2a, as an example, the following deposition process may be further performed in addition to the above steps (1) to (7):

### (8) deposition of materials

The silicon wafer that has been developed is placed in an evaporation coater, the chamber is vacuumized by a molecular pump to 10⁻⁶ Pa, and a titanium film of 2 nm and a gold film of 50 nm are thermal evaporated at rates of 1 Å/s and 0.5 Å/s respectively. The chromium film of 2 nm is used as an adhesion layer for the gold film.

### (9) removing the photoresist.

After the chamber is cooled, vacuum is broken in the chamber and the coated silicon wafer is taken out. The silicon wafer is immersed in the acetone, and is ultrasonically cleaned until the photoresist is completely removed, leaving patterns of contour lines for gold.

In the present embodiment 2a, as an example, the following etching process may be further performed in addition to the above steps (1) to (7):

### (8') dry etching

The silicon wafer after photolithography is placed in an ion etching machine, and the exposed silicon substrate is etched by plasma gas using the pattern of the photoresist as a mask, so that the pattern can be etched onto the silicon wafer at the pattern of contour lines.

### (9') removing the photoresist.

The silicon wafer is immersed in acetone and is ultrasonically cleaned until the photoresist is completely removed, thereby preparing a pattern of contour lines on the surface of the silicon wafer.

Similar to the projection exposure of Embodiment 1b, the ultraviolet direct writing exposure of Embodiment 1c, and the electron beam direct writing exposure of Embodiment 1d described above, in the present Embodiment 2, Embodiment 2a may also be modified to obtain Embodiment 2b using projection exposure, Embodiment 2c using ultraviolet direct writing exposure, and Embodiment 2d using electron beam direct writing exposure. Here, repetitive description of the projection exposure of Embodiment 2b, the ultraviolet direct writing exposure of Embodiment 2c, and the electron beam direct writing exposure of Embodiment 2d will be omitted.

### Embodiment 3

### < Photolithography Method Based on Positive Photoresist + Interlayer Film + Negative Photoresist >

Embodiment 3 of the present invention provides a photolithography method based on positive photoresist + interlayer film + negative photoresist, comprising the steps of:
(1) forming a positive photoresist layer on a substrate using a positive photoresist, forming an interlayer on the positive photoresist layer and forming a negative photoresist layer on the interlayer using a negative photoresist;
(2) patterning the negative photoresist layer and the positive photoresist layer to form a positive pattern region and a negative pattern region on the positive photoresist layer and the negative photoresist layer, respectively, wherein a size of the positive pattern region is larger than a size of the negative pattern region;
(3) developing the negative photoresist layer with developer for negative photoresist to remove the negative photoresist outside the negative pattern region;
(4) developing the interlayer with developer for interlayer, or etching the interlayer with a pattern of the developed negative photoresist layer as an anti-etching mask, so that the pattern of the interlayer matches the pattern of the developed negative photoresist layer; and
(5) developing the positive photoresist layer with developer for positive photoresist to remove the positive photoresist at an edge portion of the positive pattern region, thereby providing an exposed region associated with the size of the positive pattern region and the size of the negative pattern region, to expose the substrate.

Hereinafter, Embodiment 3 of the above-described photolithography method based on positive photoresist + interlayer film + negative photoresist will be described in detail with reference to FIGS**.** 3A, 3B, 3C, 3D, 3E, 3F and 3G. In the drawings, the same or equivalent parts are denoted by the same reference numerals. Further, repetitive description of portions similar to those of Embodiment 2 in Embodiment 3 will be omitted.

FIG. 3A is a schematic diagram showing step 1C of coating a positive photoresist on a substrate in the photolithography method according to Embodiment 3 of the present invention. FIG. 3B is a schematic diagram showing step 2C of coating an interlayer on the positive photoresist in the photolithography method according to Embodiment 3 of the present invention. FIG. 3C is a schematic diagram showing step 3C of coating a negative photoresist on the interlayer in the photolithography method according to Embodiment 3 of the present invention.

First, as shown in FIG. 3A, in step 1C, a layer of positive photoresist 103C (i.e., positive photoresist layer) is spin-coated on a substrate 101C and is dried. Then, as shown in FIG. 3B, in step 2C, an interlayer film 110C is coated on the positive photoresist 103C. Then, as shown in FIG. 3C, in step 3C, a layer of negative photoresist 102C (i.e., a negative photoresist layer) matching the positive photoresist 103C is spin-coated on the interlayer film 110C and is dried (corresponding to forming a positive photoresist layer on a substrate using a positive photoresist, forming an interlayer on the positive photoresist layer and forming a negative photoresist layer on the interlayer using a negative photoresist).

The negative photoresist includes negative ultraviolet photoresist, negative deep ultraviolet photoresist, negative extreme ultraviolet photoresist, negative electron beam photoresist, negative ion beam photoresist or negative X-ray photoresist. The positive photoresist includes positive ultraviolet photoresist, positive deep ultraviolet photoresist, positive extreme ultraviolet photoresist, positive electron beam photoresist, positive ion beam photoresist or positive X-ray photoresist.

The degree of matching for positive and negative photoresists of different Item No. needs to be confirmed in advance. Two paired groups of positive and negative photoresists are provided as follows. First group: positive photoresist of Item No. HTI 751 and negative photoresist of Item No. SUN 9i; second group: positive photoresist of Item No. AZ 1500 and negative photoresist of Item No. AZ nlof 2020.

As an example, the process of spin coating the negative photoresist (taking SUN 9i, AZ nlof 2020 as examples) is as follows: first spin coating the negative photoresist at a rotation speed of 800-1000 rotations/minute for 5-10 seconds (this step can be omitted); then spin coating the negative photoresist at a rotation speed of 4000-8000 rotations/minute for 30-40 seconds and baking the same at 95-100°C for 60-90 seconds.

As an example, the process of spin coating the positive photoresist (taking HTI 751, AZ 1500 as examples) is as follows: first spin coating the positive photoresist at a rotation speed of 800-1000 rotations/minute for 5-10 seconds (this step can be omitted); then spin coating the positive photoresist at a rotation speed of 2000-5000 rotations/minute for 30-40 seconds and baking the same at 90-100°C for 30-50 seconds.

In addition, different rotation speeds determine the thickness of the film of photoresists. Pre-bake temperature and time and subsequent exposure amount, exposure time and developing time are adjusted according to different thickness of films.

In addition, the material of the substrate includes semiconductor, metal, insulator, polymer or composite material.

FIG. 3D is a schematic diagram showing step 4C of exposing two layers of photoresist in the photolithography method according to Embodiment 3 of the present invention.

Subsequent to step 3C, as shown in FIG. 3D, in step 4C, the two layers of photoresist 102C, 103C are exposed under an exposure source using a lithographic mask with a template pattern or by focused direct writing (an example of a lithographic mask 108C is shown in FIG. 3D). After exposure, exposure patterns 104B, 105B (i.e., negative pattern region, positive pattern region) of different sizes are formed on the negative photoresist 102C and the positive photoresist 103C, respectively, and then the negative photoresist 102C and the positive photoresist 103C are dried (corresponding to patterning the negative photoresist layer and the positive photoresist layer to form a positive pattern region and a negative pattern region on the positive photoresist layer and the negative photoresist layer, respectively, wherein a size of the positive pattern region is larger than a size the negative pattern region).

The exposure source includes ultraviolet light source, deep ultraviolet light source, extreme ultraviolet light source, ion beam, electron beam or X-ray. Focused direct writing includes ultraviolet direct writing, deep ultraviolet direct writing, extreme ultraviolet direct writing, ion beam direct writing, electron beam direct writing or X-ray direct writing. The feature line width or feature dimension of the mask patterns is 2 nm-1000 µm.

As an example, the pre-baked silicon wafer as a substrate is fixed under the mask, is then placed under the ultraviolet light source, and the ultraviolet light source is turned on to perform photolithography. The exposure time is adjusted according to the paired group of positive and negative photoresists that are used. Taking the pairing mentioned above as example, the exposure flux of 100-200 mJ/cm² at the wavelength of 350-400 nm is applicable to the paired photoresist group of HTI 751 and SUN 9i, and the paired photoresist group of AZ 1500 and AZ nlof 2020. The absorption effect of negative photoresists (e.g., SUN 9i, AZ nlof 2020) of different thickness on ultraviolet radiation shall be taken into account for use of wavelength of UV and exposure flux to ensure that the underlying positive photoresist (e.g., HTI 751, AZ 1500) can obtain sufficient exposure flux. As the responses of the paired group of HTI 751 and SUN 9i and the paired group of AZ 1500 and AZ nlof 2020 to the exposure flux at specific wavelengths are different, pattern of different sizes based on the mask pattern (e.g., 104C, 105C in FIG. 3D) can be obtained.

As an example, the exposing may be in the form of single exposure. As an example, the exposing may be in the form of multiple exposures. That is, the exposure can be implemented by being divided to a plurality of exposures of a plurality of shorter periods of time or a plurality of exposure s of smaller doses.

FIG. 3E is a schematic diagram showing step 5C of developing the negative photoresist in the photolithography method according to Embodiment 3 of the present invention. FIG. 3F is a schematic diagram showing step 6C of patterning the interlayer in the photolithography method according to Embodiment 3 of the present invention. FIG. 3G is a schematic diagram showing step 7C of developing the positive photoresist in the photolithography method according to Embodiment 3 of the present invention.

Subsequent to Step 4C, as shown in FIG. 3E, in Step 5C, a negative photoresist is developed with developer for negative photoresist (corresponding to developing the negative photoresist layer with developer for negative photoresist to remove the negative photoresist outside the negative pattern region). Then, as shown in FIG. 3F, in step 6C, the interlayer film is developed with the developer for interlayer, or the interlayer film is etched with the pattern of the developed negative photoresist as an anti-etching mask, so that the pattern of the interlayer film matches the pattern of the developed negative photoresist (corresponding to developing the interlayer with developer for interlayer, or etch the interlayer with a pattern of the developed negative photoresist layer as an anti-etching mask, so that the pattern of the interlayer matches the pattern of the developed negative photoresist layer). Then, as shown in FIG. 3G, in step 7C, the positive photoresist is controllably developed with developer for positive photoresist to merely clean away the edge portion of the exposed pattern on the positive photoresist and expose the material of the substrate, so as to transform the mask pattern to pattern of contour lines (corresponding to developing the positive photoresist layer with developer for positive photoresist to remove the positive photoresist at an edge region of the positive pattern region, thereby providing an exposed region associated with the size of the positive pattern region and the size of the negative pattern region, to expose the substrate).

As an example, the exposed silicon wafer is placed in a corresponding developer for the negative photoresist, such as a TMAH developer, and the unexposed negative photoresist on the silicon wafer is cleaned away, thereby generating a pattern of the exposure pattern. Then the silicon wafer is cleaned to remove the developer, and is dried to remove residual liquid. Then, the exposed silicon wafer is placed in a corresponding developer for interlayer film, such as TMAH developer, or dry etching and the like is adopted, and the pattern of the negative photoresist is used as an anti-etching mask, so that the pattern of negative photoresist is transferred to the underlying interlayer film. Then the silicon wafer is cleaned and dried according to the situation, so that the interlayer film obtains a pattern matching or close to the pattern of negative photoresist. Thereafter, the exposed silicon wafer is placed in a corresponding developer for the positive photoresist, such as a TMAH developer, and the exposed positive photoresist on the silicon wafer is partially (not completely) cleaned away by regulating the development time. Then the silicon wafer is cleaned to remove the developer and is dried to remove the residual liquid, thereby obtaining a pattern of contour lines for the exposure pattern.

Further, if the developers for the positive photoresist, the negative photoresist, and the interlayer film are the same, or the developers for two of the positive photoresist, the negative photoresist, and the interlayer film are the same, the corresponding development steps can be combined according to the actual situation, so that the steps of cleaning and drying can be reduced. In addition, cross-experiments should be carried out on the positive photoresist, the negative photoresist and the interlayer film and the corresponding developers to formulate the most appropriate development process.

### (Embodiment 3a)

As an example, Embodiment 3a specifically includes the steps of:

### (1) coating positive photoresist

A silicon wafer is placed and fixed in the photoresist homogenizing system. The positive photoresist (e.g., HTI 751 or AZ 1500) is spin-coated at 800 rpm×5 s + 2500 rpm×30 s and is then dried at 95-100 °C for 40 seconds.

### (2) coating interlayer film

The silicon wafer is placed into a coating system for interlayer film (vapor phase coating, scraping coating, spraying or spin coating, etc.) to perform interlayer film coating. The interlayer film comprises an inorganic substance, a polymer, or a composite material. The function of he interlayer is to avoid or reduce the phenomenon that the two layers of the photoresist dissolve during the coating process.

### (3) coating negative photoresist

The cooled wafer is placed and fixed in the photoresist homogenizing system. The negative photoresist (e.g., SUN 9i or AZ nlof 2020) is spin coated at 1000 rpm×5 s + 4000 rpm×40 s and is then dried at 100-110 °C for 60 seconds.

### (4) exposure

The substrate of the silicon wafer which has undergone the above process is tightly fixed under a mask, the chamber is vacuumized and the substrate is placed right under the ultraviolet light source. The light source is turned on to perform photolithography. The exposure time is adjusted according to the kind of paired group of photoresist and the thickness of the layer of photoresist. After the exposure is finished, the mask is removed, the exposed silicon wafer is moved to a heating stage, and is baked at 100°C for 45 seconds. The exposure flux is e.g., 100 mJ/cm², which can be changed according to need.

### (5) development for negative photoresist

The exposed silicon wafer is placed in a corresponding developer for the negative photoresist, such as a TMAH developer, and the unexposed negative photoresist on the silicon wafer is cleaned away, thereby generating a pattern of the exposure pattern. Then the silicon wafer is cleaned to remove the developer, and is dried to remove residual liquid.

### (6) patterning of interlayer film

The exposed silicon wafer is placed in a corresponding developer for interlayer film, such as TMAH developer, or dry etching and the like is adopted, and the pattern of the negative photoresist is used as an anti-etching mask, so that the pattern of negative photoresist is transferred to the underlying interlayer film. Then the silicon wafer is cleaned and dried according to the situation, so that the interlayer film obtains a pattern matching or close to the pattern of negative photoresist.

### (7) development for positive photoresist

The exposed silicon wafer is placed in a corresponding developer for the positive photoresist, such as a TMAH developer, and the exposed positive photoresist on the silicon wafer is partially (not completely) cleaned away by regulating the development time. Then the silicon wafer is cleaned to remove the developer and dried to remove the residual liquid, thereby obtaining a pattern of contour lines for the exposure pattern.

Note that, if the developers for the positive photoresist, the negative photoresist, and the interlayer film are the same, or the developers for two of the positive photoresist, the negative photoresist, and the interlayer film are the same, the corresponding development steps can be combined according to the actual situation, so that the steps of cleaning and drying can be reduced

In the present embodiment 3a, as an example, the deposition process or the etching process may be further performed in addition to the above steps (1) to (7). As the specific contents of the deposition process or the etching process are similar to those in the above embodiment 2a, repetitive description thereof is omitted here.

In addition, similar to the projection exposure of Embodiment 1b, the ultraviolet direct writing exposure of Embodiment 1c, and the electron beam direct writing exposure of Embodiment 1d described above, in Embodiment 3, Embodiment 3a may be modified to obtain Embodiment 3b using projection exposure, Embodiment 3c using ultraviolet direct writing exposure, and Embodiment 3d using electron beam direct writing exposure. Here, repetitive description of the projection exposure of Embodiment 3b, the ultraviolet direct writing exposure of Embodiment 3c, and the electron beam direct writing exposure of Embodiment 3d is omitted.

As shown in FIG. 4, by adopting Embodiment 3 of the present invention, it is also possible to obtain pattern of contour lines based on a mask pattern whose line width is smaller than the line width of the mask pattern, so that the density of lines can be multiplied and miniaturization of the size of the original mask pattern can be realized. Furthermore, by coating the interlayer film between the two layers of the photoresist, it is also possible to avoid or reduce the phenomenon that the two layers of the photoresist dissolve during the coating process.

### <Photolithography System>

Hereinafter, a configuration of a photolithography system corresponding to the photolithography method according to an embodiment of the present invention will be described in detail.

FIG. 5 is a block diagram schematically showing a photolithography system corresponding to the photolithography method according to Embodiment 1 of the present invention.

As shown in FIG. 5, a photolithography system 10A corresponding to the photolithography method according to Embodiment 1 of the present invention includes a layer forming device 1001A, a patterning device 1002A, a positive photoresist developing device 1003A, and a negative photoresist developing device 1004A, and the photolithography system is configured for performing the steps of:
(1) using the layer forming device 1001A to form a negative photoresist layer on a substrate using a negative photoresist, and form a positive photoresist layer on the negative photoresist layer using a positive photoresist;
(2) using the patterning device 1002A to pattern the negative photoresist layer and the positive photoresist layer to form a positive pattern region and a negative pattern region on the positive photoresist layer and the negative photoresist layer, respectively, wherein a size of the positive pattern region is larger than a size of the negative pattern region;
(3) using the positive photoresist developing device 1003A to develop the positive photoresist layer with developer for positive photoresist to remove the positive photoresist in the positive pattern region; and
(4) using the negative photoresist developing device 1004A to develop the negative photoresist layer with developer for negative photoresist to remove the negative photoresist located near the negative pattern region, thereby providing an exposed region associated with the size of the positive pattern region and the size of the negative pattern region, to expose the substrate.

As an example, the layer forming device 1001A includes, for example, a spin coating device and a drying device. The patterning device 1002A is, for example, an exposure device. Further, the photolithography system 10A may further include, for example, a deposition/etching device, a photoresist removal device, or the like (not shown in FIG. 5), as necessary.

FIG. 6 is a block diagram schematically showing a photolithography system corresponding to the photolithography method according to Embodiment 2 of the present invention.

As shown in FIG. 6, a photolithography system 10B corresponding to the photolithography method according to Embodiment 2 of the present invention includes a layer forming device 1001B, a patterning device 1002B, a positive photoresist developing device 1003B, an interlayer developing and etching device 1005B and a negative photoresist developing device 1004B, and the photolithography system is configured for performing the steps of:
(1) using the layer forming device 1001B to form a negative photoresist layer on a substrate using a negative photoresist, form an interlayer on the negative photoresist layer and form a positive photoresist layer on the interlayer using a positive photoresist;
(2) using the patterning device 1002B to pattern the negative photoresist layer and the positive photoresist layer to form a positive pattern region and a negative pattern region on the positive photoresist layer and the negative photoresist layer, respectively, wherein a size of the positive pattern region is larger than a size of the negative pattern region;
(3) using the positive photoresist developing device 1003B to develop the positive photoresist layer with developer for positive photoresist to remove the positive photoresist in the positive pattern region;
(4) using the interlayer developing and etching device 1005B to develop the interlayer with developer for interlayer, or etch the interlayer with a pattern of the developed positive photoresist layer as an anti-etching mask, so that the pattern of the interlayer matches the pattern of the developed positive photoresist layer; and
(5) using the negative photoresist developing device 1004B to develop the negative photoresist layer with developer for negative photoresist to remove the negative photoresist located near the negative pattern region, thereby providing an exposed region associated with the size of the positive pattern region and the size of the negative pattern region, to expose the substrate.

As an example, the layer forming device 1001B includes, for example, a spin coating device and a drying device. The patterning device 1002B is, for example, an exposure device. Further, the photolithography system 10B may further include, for example, a deposition/etching device, a photoresist removal device, or the like (not shown in FIG. 6), as necessary.

FIG. 7 is a block diagram schematically showing a photolithography system corresponding to the photolithography method according to Embodiment 3 of the present invention.

As shown in FIG. 7, a photolithography system 10C corresponding to the photolithography method according to Embodiment 3 of the present invention includes a layer forming device 1001C, a patterning device 1002C, a negative photoresist developing device 1004C, an interlayer developing and etching device 1005C and a positive photoresist developing device 1003C, and the photolithography system is configured for performing the steps of:
(1) using the layer forming device 1001C to form a positive photoresist layer on a substrate using a positive photoresist, form an interlayer on the positive photoresist layer and form a negative photoresist layer on the interlayer using a negative photoresist;
(2) using the patterning device 1002C to pattern the negative photoresist layer and the positive photoresist layer to form a positive pattern region and a negative pattern region on the positive photoresist layer and the negative photoresist layer, respectively, wherein the positive pattern region is larger than the negative pattern region;
(3) using the negative photoresist developing device 1004C to develop the negative photoresist layer with developer for negative photoresist to remove the negative photoresist outside the negative pattern region;
(4) using the interlayer developing and etching device 1005C to develop the interlayer with developer for interlayer, or etch the interlayer with a pattern of the developed negative photoresist layer as an anti-etching mask, so that the pattern of the interlayer matches the pattern of the developed negative photoresist layer; and
(5) using the positive photoresist developing device 1003C to develop the positive photoresist layer with developer for positive photoresist to remove the positive photoresist at an edge portion of the positive pattern region, thereby providing an exposed region associated with the size of the positive pattern region and the size of the negative pattern region, to expose the substrate.

As an example, the layer forming device 1001C includes, for example, a spin coating device and a drying device. The patterning device 1,002C is, for example, an exposure device. Further, the photolithography system 10C may further include, for example, a deposition/etching device, a photoresist removal device, or the like (not shown in FIG. 7), as necessary.

In addition, the present invention also provides a method of controlling a photolithography system for controlling the steps performed by the photolithography system described above.

In addition, the present invention further provides a computer device comprising a memory, a processor, and computer program that is stored in the memory and can run on the processor, characterized in that the processor implements the method of controlling a photolithography system described above when executing the computer program.

In addition, the present invention also provides a computer readable medium having computer program stored thereon, which when executed by a processor implements the method of controlling photolithography system described above.

### Industrial Applicability

The photolithography method and the photolithography system according to the present invention can be widely used in the technical fields of semiconductor process, chip manufacturing, etc. and has extensive values of research and application.

## Claims

1. A photolithography method, wherein the method comprises:
(1) forming a negative photoresist layer on a substrate using a negative photoresist, and forming a positive photoresist layer on the negative photoresist layer using a positive photoresist;
(2) patterning the negative photoresist layer and the positive photoresist layer to form a positive pattern region on the positive photoresist layer and a negative pattern region on the negative photoresist layer, wherein a size of the positive pattern region is larger than a size of the negative pattern region;
(3) developing the positive photoresist layer with developer for positive photoresist to remove the positive photoresist in the positive pattern region; and
(4) developing the negative photoresist layer with developer for negative photoresist to remove the negative photoresist located near the negative pattern region, thereby providing an exposed region associated with a size of the positive pattern region and a size of the negative pattern region, to expose the substrate.

2. A photolithography method, wherein the method comprises:
(1) forming a negative photoresist layer on a substrate using a negative photoresist, forming an interlayer on the negative photoresist layer and forming a positive photoresist layer on the interlayer using a positive photoresist;
(2) patterning the negative photoresist layer and the positive photoresist layer to form a positive pattern region on the positive photoresist layer and a negative pattern region on the negative photoresist layer, wherein a size of the positive pattern region is larger than a size of the negative pattern region;
(3) developing the positive photoresist layer with developer for positive photoresist to remove the positive photoresist in the positive pattern region;
(4) developing the interlayer with developer for interlayer, or etching the interlayer with a pattern of the developed positive photoresist layer as an anti-etching mask, so that the pattern of the interlayer matches the pattern of the developed positive photoresist layer; and
(5) developing the negative photoresist layer with developer for negative photoresist to remove the negative photoresist located near the negative pattern region, thereby providing an exposed region associated with a size of the positive pattern region and a size of the negative pattern region, to expose the substrate.

3. A photolithography method, wherein the method comprises:
(1) forming a positive photoresist layer on a substrate using a positive photoresist, forming an interlayer on the positive photoresist layer and forming a negative photoresist layer on the interlayer using a negative photoresist;
(2) patterning the negative photoresist layer and the positive photoresist layer to form a positive pattern region on the positive photoresist layer and a negative pattern region on the negative photoresist layer, wherein a size of the positive pattern region is larger than a size of the negative pattern region;
(3) developing the negative photoresist layer with developer for negative photoresist to remove the negative photoresist outside the negative pattern region;
(4) developing the interlayer with developer for interlayer, or etching the interlayer with a pattern of the developed negative photoresist layer as an anti-etching mask, so that the pattern of the interlayer matches the pattern of the developed negative photoresist layer; and
(5) developing the positive photoresist layer with developer for positive photoresist to remove the positive photoresist at an edge portion of the positive pattern region, thereby providing an exposed region associated with a size of the positive pattern region and a size of the negative pattern region, to expose the substrate.

4. The photolithography method according to any one of claims 1-3, wherein
in the step (2), under an exposure source, the positive photoresist layer and the negative photoresist layer are exposed by using a lithographic mask with a template pattern or by focused direct writing, thereby forming a positive pattern region on the positive photoresist layer and a negative pattern region on the negative photoresist layer.

5. The photolithography method of claim 4, wherein,
in the step (2),
the positive photoresist layer and the negative photoresist layer are exposed through a lithography mask with the template pattern under an exposure source by means of a projection exposure; or
the positive photoresist layer and the negative photoresist layer are exposed through a photolithographic mask with the template pattern under an exposure source by means of masking exposure; or
the positive photoresist layer and the negative photoresist layer are exposed by reflection on a lithographic mask with the template pattern under an exposure source by means of reflective exposure.

6. The photolithography method of claim 4, wherein,
the focused direct writing includes ultraviolet direct writing, deep ultraviolet direct writing, extreme ultraviolet direct writing, ion beam direct writing, electron beam direct writing or X-ray direct writing.

7. The photolithography method of claim 4, wherein,
the wavelength of the exposure source is 1 to 500 nm, and the temperature for the drying after the exposure is 30 to 300 °C.

8. The photolithography method according to any one of claims 1-3, wherein
the positive photoresist includes positive ultraviolet photoresist, positive deep ultraviolet photoresist, positive extreme ultraviolet photoresist, positive electron beam photoresist, positive ion beam photoresist or positive X-ray photoresist;
the negative photoresist includes negative ultraviolet photoresist, negative deep ultraviolet photoresist, negative extreme ultraviolet photoresist, negative electron beam photoresist, negative ion beam photoresist or negative X-ray photoresist.

9. The photolithography method according to any one of claims 1-3, wherein
the developer for positive photoresist is a developer corresponding to the positive photoresist,
the developer for negative photoresist is a developer corresponding to the negative photoresist.

10. The photolithography method according to any one of claims 1-3, wherein the method further comprises the step of:
forming a pattern on the substrate through material deposition technology or etching technology.

11. The photolithography method of claim 10, wherein
the material deposition technology includes electrochemical deposition, electroplating, CVD deposition, laser sputtering, magnetron sputtering, thermal evaporation, electron beam evaporation or atomic deposition;
the etching technology includes wet etching including electrochemical etching or selective etching liquid etching or dry etching including ion etching or chemical reactive ion etching.

12. The photolithography method according to any one of claims 1-3, wherein
the material of the substrate includes semiconductor, metal, insulator, polymer or composite material.

13. The photolithography method of claim 2 or claim 3, wherein
the interlayer comprises an inorganic substance, a polymer, or a composite material.

14. A photolithography system comprising a layer forming device, a patterning device, a positive photoresist developing device, and a negative photoresist developing device, the lithographic system is configured for performing the steps of:
(1) using the layer forming device to form a negative photoresist layer on a substrate using a negative photoresist, and form a positive photoresist layer on the negative photoresist layer using a positive photoresist;
(2) using the patterning device to pattern the negative photoresist layer and the positive photoresist layer to form a positive pattern region on the positive photoresist layer and a negative pattern region on the negative photoresist layer, wherein a size of the positive pattern region is larger than a size of the negative pattern region;
(3) using the positive photoresist developing device to develop the positive photoresist layer with developer for positive photoresist to remove the positive photoresist in the positive pattern region; and
(4) using the negative photoresist developing device to develop the negative photoresist layer with developer for negative photoresist to remove the negative photoresist located near the negative pattern region, thereby providing an exposed region associated with a size of the positive pattern region and a size the negative pattern region, to expose the substrate.

15. A photolithography system comprising a layer forming device, a patterning device, a positive photoresist developing device, an interlayer developing device and a negative photoresist developing device, the lithographic system is configured for performing the steps of:
(1) using the layer forming device to form a negative photoresist layer on a substrate using a negative photoresist, form an interlayer on the negative photoresist layer and form a positive photoresist layer on the interlayer using a positive photoresist;
(2) using the patterning device to pattern the negative photoresist layer and the positive photoresist layer to form a positive pattern region on the positive photoresist layer and a negative pattern region on the negative photoresist layer, wherein a size of the positive pattern region is larger than a size of the negative pattern region;
(3) using the positive photoresist developing device to develop the positive photoresist layer with developer for positive photoresist to remove the positive photoresist in the positive pattern region;
(4) using the interlayer developing and etching device to develop the interlayer with developer for interlayer, or etch the interlayer with a pattern of the developed negative photoresist layer as an anti-etching mask, so that the pattern of the interlayer matches the pattern of the developed negative photoresist layer; and
(5) using the negative photoresist developing device to develop the negative photoresist layer with developer for negative photoresist to remove the negative photoresist located near the negative pattern region, thereby providing an exposed region associated with a size of the positive pattern region and a size of the negative pattern region, to expose the substrate.

16. A photolithography system comprising a layer forming device, a patterning device, a negative photoresist developing device, an interlayer developing device and a positive photoresist developing device, the lithographic system is configured for performing the steps of:
(1) using the layer forming device to form a positive photoresist layer on a substrate using a positive photoresist, form an interlayer on the positive photoresist layer and form a negative photoresist layer on the interlayer using a negative photoresist;
(2) using the patterning device to pattern the negative photoresist layer and the positive photoresist layer to form a positive pattern region on the positive photoresist layer and a negative pattern region on the negative photoresist layer, wherein a size of the positive pattern region is larger than a size of the negative pattern region;
(3) using the negative photoresist developing device to develop the negative photoresist layer with developer for negative photoresist to remove the negative photoresist outside the negative pattern region;
(4) using the interlayer developing and etching device to develop the interlayer with developer for interlayer, or etch the interlayer with a pattern of the developed negative photoresist layer as an anti-etching mask, so that the pattern of the interlayer matches the pattern of the developed negative photoresist layer; and
(5) using the positive photoresist developing device to develop the positive photoresist layer with developer for positive photoresist to remove the positive photoresist at an edge portion of the positive pattern region, thereby providing an exposed region associated with a size of the positive pattern region and a size of the negative pattern region, to expose the substrate.

17. A method of controlling photolithography system for controlling the steps performed by the photolithography system of any one of claims 14-16.

18. A computer device comprising a memory, a processor, and computer program that is stored in the memory and can run on the processor, **characterized in that** the processor implements the method of controlling a photolithography system of claim 17 when executing the computer program.

19. A computer readable medium having computer program stored thereon, which when executed by a processor implements the method of controlling photolithography system of claim 17.
